(19) Europäisches Patentamt
European Patent Office
Office européen des brevets

(11) EP 4 600 318 A1

(12) EUROPEAN PATENT APPLICATION
published in accordance with Art. 153(4) EPC

(43) Date of publication:
**13.08.2025 Bulletin 2025/33**

(21) Application number: **23885860.9**

(22) Date of filing: **02.11.2023**

(51) International Patent Classification (IPC):
***C09D 133/10*** (2006.01) ***C09D 5/02*** (2006.01)
***C09D 5/44*** (2006.01) ***C09D 127/12*** (2006.01)
***H01B 7/02*** (2006.01)

(52) Cooperative Patent Classification (CPC):
**C08F 20/18; C09D 5/02; C09D 5/03; C09D 5/44; C09D 127/12; C09D 127/18; C09D 133/00; C09D 133/10; H01B 7/02; H05K 1/03; H05K 1/05**

(86) International application number:
**PCT/JP2023/039665**

(87) International publication number:
**WO 2024/096106 (10.05.2024 Gazette 2024/19)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.11.2022 JP 2022176619**

(71) Applicant: **DAIKIN INDUSTRIES, LTD.**
**Osaka-shi, Osaka 530-0001 (JP)**

(72) Inventors:
- **NAKATANI, Yasukazu**
  **Osaka-Shi, Osaka 530-0001 (JP)**
- **KADOWAKI, Yu**
  **Osaka-Shi, Osaka 530-0001 (JP)**
- **NAGATO, Masaru**
  **Osaka-Shi, Osaka 530-0001 (JP)**
- **MIKAME, Daisuke**
  **Osaka-Shi, Osaka 530-0001 (JP)**
- **OGITA, Koichiro**
  **Osaka-Shi, Osaka 530-0001 (JP)**
- **KONO, Hideki**
  **Osaka-Shi, Osaka 530-0001 (JP)**
- **SUKEGAWA, Masamichi**
  **Osaka-Shi, Osaka 530-0001 (JP)**

(74) Representative: **Hoffmann Eitle**
**Patent- und Rechtsanwälte PartmbB**
**Arabellastraße 30**
**81925 München (DE)**

(54) **ELECTRODEPOSITION COATING COMPOSITION, FILM, COATED ARTICLE, COATED WIRE, AND PRINTED CIRCUIT BOARD**

(57) Provided is an electrodeposition coating material composition comprising a perfluoropolymer compound X and a neutralized product of a methacrylate resin, wherein the perfluoropolymer compound X has a relative dielectric constant of 2.0 to 2.2, the methacrylate resin has an acid value of 10 mgKOH/g or more, and the electrodeposition coating material composition has a solid concentration of 10 to 70% by mass.

EP 4 600 318 A1

## Description

### TECHNICAL FIELD

The present disclosure relates to an electrodeposition coating material composition, a film, a coated article, a coated electric wire, and a printed circuit board.

### BACKGROUND ART

Patent Document 1 discloses a method for manufacturing an insulated electric wire, the method comprising electrically depositing onto a conductor a water-dispersed resin emulsion obtained by dispersing a polyimide resin, a fluororesin, and a charge imparting agent in water, and drying and baking the emulsion to form an insulating layer.
Patent Document 2 discloses a method for manufacturing a low dielectric constant copper-clad insulating film, the method comprising forming an electrically deposited precipitation layer by electrodeposition coating on a copper foil, on which a fibrous substrate is polymerized, using as an electrodeposition coating material a liquid obtained by emulsion-polymerizing a vinyl monomer having good thermal decomposability in an aqueous dispersion of a fluororesin, and thermally decomposing and volatilizing the vinyl polymer to form an insulating film.

### RELATED ART

### PATENT DOCUMENTS

Patent Document 1: Japanese Patent Laid-Open No. 2002-298674
Patent Document 2: Japanese Patent Laid-Open No. S61-042822

### SUMMARY OF THE INVENTION

### PROBLEM TO BE SOLVED BY THE INVENTION

An object of the present disclosure is to provide an electrodeposition coating material composition that can be prepared without using a material containing a metal component and that can provide a crack-free film.

### MEANS FOR SOLVING THE PROBLEM

The present disclosure provides an electrodeposition coating material composition comprising a perfluoropolymer compound X and a neutralized product of a methacrylate resin, wherein the perfluoropolymer compound X has a relative dielectric constant of 2.0 to 2.2, the methacrylate resin has an acid value of 10 mgKOH/g or more, and the electrodeposition coating material composition has a solid concentration of 10 to 70% by mass.

### EFFECTS OF INVENTION

The present disclosure can provide an electrodeposition coating material composition that can be prepared without using a material containing a metal component and that can provide a crack-free film.

### BRIEF DESCRIPTION OF DRAWINGS

Figure 1 is a front view and a top view of a coated electric wire having a bent part according to one embodiment.
Figure 2 is a cross-sectional view of a coated electric wire having a bent part according to one embodiment.

### DESCRIPTION OF EMBODIMENTS

Hereinafter, specific embodiments of the present disclosure will now be described in detail, but the present disclosure is not limited to the following embodiments.
The first electrodeposition coating material composition of the present disclosure contains a perfluoropolymer compound X and a neutralized product of a methacrylate resin. In the first electrodeposition coating material composition, the perfluoropolymer compound X has a relative dielectric constant of 2.0 to 2.2, the methacrylate resin has an acid value of

10 mgKOH/g or more, and the electrodeposition coating material composition has a solid concentration of 10 to 70% by mass.

Conventionally, a known electrodeposition coating material composition is a water-dispersed resin emulsion obtained by dispersing a polyimide resin, a fluororesin, and a charge imparting agent in water as described in Patent Document 1. According to Patent Document 1, the use of such a water-dispersed resin emulsion makes it possible to attain a flat insulated electric wire having an insulating layer which has sufficient insulating properties, the thickness on the long side of which is as small as possible and, moreover, which has excellent heat resistance.

Patent Document 2 discloses a technique in which a liquid obtained by emulsion-polymerizing a vinyl monomer having good thermal decomposability in an aqueous dispersion of a fluororesin is used as an electrodeposition coating material although it is not an electrodeposition coating material composition used to form a film of a coated electric wire. A nonionic, anionic, cationic, or like surfactant is used when emulsion-polymerizing a vinyl monomer in an aqueous dispersion of a fluororesin. The surfactant is, for example, sodium lauryl sulfate.

However, the metal component contained in the surfactant remains in the eventually obtained film, and deteriorates the electrical properties of the film. Accordingly, there is a need for an electrodeposition coating material composition that can be prepared without using a material containing a metal component and that can provide a crack-free film.

The first electrodeposition coating material composition of the present disclosure contains a perfluoropolymer compound having a low relative dielectric constant and a neutralized product of a methacrylate resin obtained by neutralizing a methacrylate resin having a high acid value. It was found that such an electrodeposition coating material composition can be prepared without using a material containing a metal component and, also, electrodeposition-coating a substrate with such an electrodeposition coating material composition can provide a crack-free film on the substrate. Moreover, the resulting film has a low surface roughness, firmly adheres to the substrate, and has a low relative dielectric constant.

The second electrodeposition coating material composition of the present disclosure contains a perfluoropolymer compound X and a neutralized product of a methacrylate resin. In the second electrodeposition coating material composition, the perfluoropolymer compound X is a tetrafluoroethylene/fluoroalkyl vinyl ether copolymer, the methacrylate resin has an acid value of 10 mgKOH/g or more, and the electrodeposition coating material composition has a solid concentration of 10 to 70% by mass.

The second electrodeposition coating material composition of the present disclosure contains a tetrafluoroethylene/fluoroalkyl vinyl ether copolymer as a perfluoropolymer compound, and also contains a neutralized product of a methacrylate resin obtained by neutralizing a methacrylate resin having a high acid value. It was found that such an electrodeposition coating material composition can be prepared without using a material containing a metal component and, also, electrodeposition-coating a substrate with such an electrodeposition coating material composition can provide a crack-free film on the substrate. Moreover, the resulting film has a low surface roughness, firmly adheres to the substrate, and has a low relative dielectric constant.

Below, the respective components of the electrodeposition coating material composition of the present disclosure will now be described in detail.

(Perfluoropolymer compound X)

The electrodeposition coating material composition of the present disclosure contains a perfluoropolymer compound X. In the present disclosure, the perfluoropolymer compound is a polymer compound having a perfluoromonomer unit content of 90 mol% or more based on all polymerization units constituting the polymer compound.

In the present disclosure, the perfluoromonomer is a monomer that does not contain a carbon atom-hydrogen atom bond within the molecule. The perfluoromonomer may be a monomer containing carbon atoms and fluorine atoms in which some of the fluorine atoms bonded to any of the carbon atoms are replaced with chlorine atoms, and may be a monomer containing a nitrogen atom, an oxygen atom, a sulfur atom, a phosphorus atom, a boron atom, or a silicon atom in addition to the carbon atoms. The perfluoromonomer is preferably a monomer in which all hydrogen atoms are replaced with fluorine atoms.

The relative dielectric constant of the perfluoropolymer compound X is preferably 2.0 to 2.2 because a film exhibiting a lower relative dielectric constant can be obtained. The relative dielectric constant of the perfluoropolymer compound X can be measured at a temperature of 23°C $\pm$ 2°C at a relative humidity of 50% at a frequency of 1 KHz in accordance with JIS-C-2138.

The perfluoropolymer compound X is preferably a perfluorofluororesin. In the present disclosure, the fluororesin is a partially crystalline fluoropolymer which is a fluoroplastic. The fluororesin has a melting point and has thermoplasticity, and may be either melt-fabricable or non melt-processible.

The perfluoropolymer compound X is preferably at least one selected from the group consisting of polytetrafluoroethylene, a tetrafluoroethylene (TFE)/fluoroalkyl vinyl ether (FAVE) copolymer, a tetrafluoroethylene (TFE)/hexafluoropropylene (HFP) copolymer, and a TFE/FAVE/HFP copolymer.

Polytetrafluoroethylene (PTFE) may be either non melt-processible PTFE or melt-fabricable PTFE, and is preferably non melt-processible PTFE. In one embodiment, the perfluoropolymer compound X may be PTFE having a relative dielectric constant of 2.0 to 2.2.

Non melt-processible PTFE is usually stretchable, fibrillatable, and non-melt secondary processible. The term "non-melt secondary processible" means a property that the melt flow rate cannot be measured at a temperature higher than the crystal melting point, or that is to say, a property that does not allow it to easily flow even in the melting temperature region, in accordance with ASTM D 1238 and D 2116.

PTFE may be either a tetrafluoroethylene (TFE) homopolymer or modified PTFE containing a TFE unit and a modifying monomer unit. In the present disclosure, the term "modified PTFE" means a product obtained by copolymerizing TFE with a small amount of a comonomer that does not impart melt fabricability to the resulting copolymer. The comonomer is not limited, and examples include hexafluoropropylene [HFP], chlorotrifluoroethylene [CTFE], and perfluoro(alkyl vinyl ether) [PAVE]. The proportion of the comonomer added to modified PTFE varies depending on its type, and is preferably, for example, 0.001 to 1% by mass based on the total mass of TFE and a small amount of the comonomer. In the present disclosure, the content of each monomer unit constituting PTFE can be calculated by suitably combining NMR, FT-IR, elemental analysis, and fluorescent X-ray analysis according to the type of monomer.

PTFE preferably has a standard specific gravity (SSG) of 2.280 or less, more preferably 2.210 or less, and even more preferably 2.200 or less, and is preferably 2.130 or more. SSG is determined by the water replacement method in accordance with ASTM D 792 using a sample formed in accordance with ASTM D 4895-89.

PTFE preferably has a peak temperature in the range of 333 to 347°C. More preferably, the peak temperature is 335°C or higher and 345°C or lower. The peak temperature is a temperature corresponding to the maximum value in the heat-of-fusion curve when PTFE having no history of being heated to a temperature of 300°C or higher is heated at a rate of 10°C/min using a differential scanning calorimeter (DSC).

The perfluoropolymer compound X may be a melt-fabricable perfluoropolymer compound. In the present disclosure, the term "melt-fabricable" means that a polymer can be melted and processed using a conventional processing apparatus such as an extruder or an injection molding machine. Accordingly, the melt-fabricable perfluoropolymer compound usually has a melt flow rate of 0.01 to 500 g/10 min. In one embodiment, the perfluoropolymer compound X may be a melt-fabricable perfluoropolymer compound having a relative dielectric constant of 2.0 to 2.2.

The melt flow rate of the perfluoropolymer compound X is preferably 0.1 to 100 g/10 min, more preferably 80 g/10 min or less, and even more preferably 70 g/10 min or less, and is preferably 5 g/10 min or more and more preferably 10 g/10 min or more.

The MFR of the perfluoropolymer compound X is a value obtained as the mass of the polymer flowing out from a nozzle having an inner diameter of 2.1 mm and a length of 8 mm per 10 min (g/10 min) at 372°C under a load of 5 kg using a melt indexer (manufactured by YASUDA SEIKI SEISAKUSHO, LTD.) in accordance with to ASTM D 1238.

The melting point of the perfluoropolymer compound X is preferably 200 to 322°C, more preferably 230°C or higher, and even more preferably 250°C or higher, and is more preferably 320°C or lower.

The melting point can be measured by using a differential scanning calorimeter [DSC].

The melt-fabricable perfluoropolymer compound X, in particular, is preferably at least one selected from the group consisting of a TFE/FAVE copolymer, a TFE/HFP copolymer, and a TFE/FAVE/HFP copolymer.

The TFE/FAVE copolymer is a copolymer containing a tetrafluoroethylene (TFE) unit and a fluoroalkyl vinyl ether (FAVE) unit. In one embodiment, the perfluoropolymer compound X may be a TFE/FAVE copolymer having a relative dielectric constant of 2.0 to 2.2.

FAVE constituting the FAVE unit may be at least one selected from the group consisting of monomers represented by the general formula (1):

$$CF_2{=}CFO(CF_2CFY^1O)_p\text{-}(CF_2CF_2CF_2O)_q\text{-}Rf \qquad (1)$$

wherein $Y^1$ represents F or $CF_3$, Rf represents a perfluoroalkyl group having 1 to 5 carbon atoms, p represents an integer of 0 to 5, and q represents an integer of 0 to 5; and monomers represented by the general formula (2):

$$CFX{=}CXOCF_2OR^1 \qquad (2)$$

wherein X is the same or different, and represents H, F or $CF_3$, and $R^1$ represents a linear or branched fluoroalkyl group having 1 to 6 carbon atoms and optionally having one or two atoms of at least one selected from the group consisting of H, Cl, Br and I, or a cyclic fluoroalkyl group having 5 or 6 carbon atoms and optionally having one or two atoms of at least one selected from the group consisting of H, Cl, Br and I.

FAVE, in particular, is preferably a monomer represented by the general formula (1), more preferably at least one selected from the group consisting of perfluoro(methyl vinyl ether), perfluoro(ethyl vinyl ether) (PEVE), and perfluoro(propyl vinyl ether) (PPVE), even more preferably at least one selected from the group consisting of PEVE and PPVE, and particularly preferably PPVE.

The content of the FAVE unit in the TFE/FAVE copolymer, based on all monomer units, is preferably 1.0 to 30.0 mol%, more preferably 1.2 mol% or more, even more preferably 1.4 mol% or more, yet more preferably 1.6 mol% or more, and particularly preferably 1.8 mol% or more, and is more preferably 3.5 mol% or less, even more preferably 3.2 mol% or less, yet more preferably 2.9 mol% or less, and particularly preferably 2.6 mol% or less.

The content of the TFE unit in the TFE/FAVE copolymer, based on all monomer units, is preferably 99.0 to 70.0 mol%, more preferably 96.5 mol% or more, even more preferably 96.8 mol% or more, yet more preferably 97.1 mol% or more, and particularly preferably 97.4 mol% or more, and is more preferably 98.8 mol% or less, even more preferably 98.6 mol% or less, yet more preferably 98.4 mol% or less, and particularly preferably 98.2 mol% or less.

In the present disclosure, the content of each monomer unit in the copolymer is measured by $^{19}$F-NMR method.

The TFE/FAVE copolymer can also contain a monomer unit derived from a monomer copolymerizable with TFE and FAVE. In this case, the content of the monomer copolymerizable with TFE and FAVE, based on all monomer units of the TFE/FAVE copolymer, is preferably 0 to 29.0 mol%, more preferably 0.1 to 5.0 mol%, and even more preferably 0.1 to 1.0 mol%.

Examples of the monomer copolymerizable with TFE and FAVE include HFP, vinyl monomers represented by $CZ^1Z^2=CZ^3(CF_2)_nZ^4$ (wherein $Z^1$, $Z^2$ and $Z^3$ are the same or different, and represent H or F; $Z^4$ represents H, F or Cl; and n represents an integer of 2 to 10), alkyl perfluorovinyl ether derivatives represented by $CF_2=CF-OCH_2-Rf^1$ (wherein $Rf^1$ represents a perfluoroalkyl group having 1 to 5 carbon atoms), and monomers having a functional group. In particular, HFP is preferable.

The TFE/FAVE copolymer is preferably at least one selected from the group consisting of a copolymer composed solely of a TFE unit and a FAVE unit, and the above TFE/HFP/FAVE copolymer, and is more preferably a copolymer composed solely of a TFE unit and a FAVE unit.

The melting point of the TFE/FAVE copolymer is preferably 280 to 322°C and more preferably 285°C or higher, and is more preferably 320°C or lower and even more preferably 315°C or lower. The melting point can be measured by using a differential scanning calorimeter [DSC].

The glass transition temperature (Tg) of the TFE/FAVE copolymer is preferably 70 to 110°C and more preferably 80°C or higher, and is more preferably 100°C or lower. The glass transition temperature can be measured by a dynamic viscoelasticity measurement.

The TFE/HFP copolymer is a copolymer containing a tetrafluoroethylene (TFE) unit and a hexafluoropropylene (HFP) unit.

The content of the HFP unit in the TFE/HFP copolymer, based on all monomer units, is preferably 0.1 to 30.0 mol%, more preferably 0.7 mol% or more, and even more preferably 1.4 mol% or more, and is more preferably 10.0 mol% or less.

The content of the TFE unit in the TFE/HFP copolymer, based on all monomer units, is preferably 70.0 to 99.9 mol% and more preferably 90.0 mol% or more, and is more preferably 99.3 mol% or less and even more preferably 98.6 mol% or less.

The TFE/HFP copolymer can also contain a monomer unit derived from a monomer copolymerizable with TFE and HFP. In this case, the content of the monomer copolymerizable with TFE and HFP, based on all monomer units of the TFE/HFP copolymer, is preferably 0 to 29.9 mol%, more preferably 0.1 to 5.0 mol%, and even more preferably 0.1 to 1.0 mol%.

Examples of the monomer copolymerizable with TFE and HFP include FAVE, vinyl monomers represented by $CZ^1Z^2=CZ^3(CF_2)_nZ^4$ (wherein $Z^1$, $Z^2$ and $Z^3$ are the same or different, and represent H or F; $Z^4$ represents H, F or Cl; and n represents an integer of 2 to 10), alkyl perfluorovinyl ether derivatives represented by $CF_2=CF-OCH_2-Rf^1$ (wherein $Rf^1$ represents a perfluoroalkyl group having 1 to 5 carbon atoms), and monomers having a functional group. In particular, FAVE is preferable.

The melting point of the TFE/HFP copolymer is preferably 200 to 322°C, more preferably 210°C or higher, even more preferably 220°C or higher, and particularly preferably 240°C or higher, and is more preferably 320°C or lower, even more preferably lower than 300°C, and particularly preferably 280°C or lower.

The glass transition temperature (Tg) of the TFE/HFP copolymer is preferably 60 to 110°C and more preferably 65°C or higher, and is more preferably 100°C or lower.

The fluorine-containing polymer compound may have a functional group.

The functional group is preferably at least one selected from the group consisting of a carbonyl group-containing group, an amino group, a hydroxy group, a $-CF_2H$ group, an olefin group, an epoxy group, and an isocyanate group.

The carbonyl group-containing group is a group containing a carbonyl group (-C(=O)-) within the structure. Examples of the carbonyl group-containing group include:

a carbonate group [$-O-C(=O)-OR^3$ wherein $R^3$ is an alkyl group having 1 to 20 carbon atoms or an alkyl group having 2

to 20 carbon atoms and containing an etheric oxygen atom];
an acyl group [-C(=O)-$R^3$ wherein $R^3$ is an alkyl group having 1 to 20 carbon atoms or an alkyl group having 2 to 20 carbon atoms and containing an etheric oxygen atom];
a haloformyl group [-C(=O)$X^5$ wherein $X^5$ is a halogen atom];
a formyl group [-C(=O)H];
a group represented by the formula: -$R^4$-C(=O)-$R^5$ wherein $R^4$ is a divalent organic group having 1 to 20 carbon atoms, and $R^5$ is a monovalent organic group having 1 to 20 carbon atoms;
a group represented by the formula: -O-C(=O)-$R^6$ wherein $R^6$ is an alkyl group having 1 to 20 carbon atoms or an alkyl group having 2 to 20 carbon atoms and containing an etheric oxygen atom;
a carboxyl group [-C(=O)OH];
an alkoxycarbonyl group [-C(=O)$OR^7$ wherein $R^7$ is a monovalent organic group having 1 to 20 carbon atoms];
a carbamoyl group [-C(=O)$NR^8R^9$ wherein $R^8$ and $R^9$ may be the same or different and are each a hydrogen atom or a monovalent organic group having 1 to 20 carbon atoms]; and
an acid anhydride bond [-C(=O)-O-C(=O)-].

Specific examples of $R^3$ include a methyl group, an ethyl group, a propyl group, an isopropyl group, and a butyl group. Specific examples of $R^4$ include a methylene group, - $CF_2$- group, and -$C_6H_4$- group; and specific examples of $R^5$ include a methyl group, an ethyl group, a propyl group, an isopropyl group, and a butyl group. Specific examples of $R^7$ include a methyl group, an ethyl group, a propyl group, an isopropyl group, and a butyl group. Also, specific examples of $R^8$ and $R^9$ include a hydrogen atom, a methyl group, an ethyl group, a propyl group, an isopropyl group, a butyl group, and a phenyl group.

The hydroxy group is a group represented by -OH or a group containing a group represented by -OH. In the present disclosure, -OH constituting a carboxyl group is not encompassed within the hydroxy group. Examples of the hydroxy group include -OH, a methylol group, and an ethylol group.

The olefinic group is a group having a carbon-carbon double bond. Examples of the olefin group include functional groups represented by the following formula:

$$-CR^{10}=CR^{11}R^{12}$$

(wherein $R^{10}$, $R^{11}$, and $R^{12}$ may be the same or different, and are each a hydrogen atom, a fluorine atom, or a monovalent organic group having 1 to 20 carbon atoms), and the olefin group is preferably at least one selected from the group consisting of -CF=$CF_2$, -CH=$CF_2$, -CF=CHF, -CF=$CH_2$, and -CH=$CH_2$.

The isocyanate group is a group represented by - N=C=O.

Examples of the functional group also include non-fluorinated alkyl groups or partially fluorinated alkyl groups such as a -$CH_3$ group and a -$CFH_2$ group.

The number of functional groups in the perfluoropolymer compound X is preferably 5 to 2,000 per $10^6$ carbon atoms because a film that adheres more firmly to the substrate can be formed. The number of functional groups per $10^6$ carbon atoms is more preferably 50 or more, even more preferably 100 or more, and particularly preferably 200 or more, and is more preferably 1,000 or less, even more preferably 800 or less, particularly preferably 700 or less, and most preferably 500 or less.

The number of functional groups in the perfluoropolymer compound X per $10^6$ carbon atoms may be less than 5, and may be 0 to 4, because a film having excellent electrical properties can be formed.

The functional group is a functional group present at a main-chain terminal or a side-chain terminal of the perfluoropolymer compound X and a functional group present in the main chain or a side chain, and is preferably present at a main-chain terminal. Examples of the functional group include -CF=$CF_2$, -$CF_2$H, -COF, -COOH, -$COOCH_3$, -$CONH_2$, -OH, and -$CH_2$OH, and the functional group is preferably at least one selected from the group consisting of -$CF_2$H, -COF, -COOH, -$COOCH_3$, and - $CH_2$OH. -COOH encompasses a dicarboxylic acid anhydride group (-CO-O-CO-) formed by the bonding of two -COOH groups.

Infrared spectroscopy can be used to identify the kind of functional group and measure the number of functional groups.

The number of functional groups is measured, specifically, by the following method. First, the copolymer is melted at 330 to 340°C for 30 minutes, and compression-molded to prepare a film having a thickness of 0.20 to 0.25 mm. The film is analyzed by Fourier transform infrared spectroscopy to obtain an infrared absorption spectrum of the copolymer, and a difference spectrum against a base spectrum that is completely fluorinated and has no functional groups is obtained. From an absorption peak of a specific functional group observed on this difference spectrum, the number N of functional groups per $1\times10^6$ carbon atoms in the copolymer is calculated according to the following formula (A).

$$N = I \times K/t \quad (A)$$

I: absorbance
K: correction factor
t: thickness of film (mm)

For reference, the absorption frequencies, the molar absorption coefficients, and the correction factors of the functional groups in the present disclosure are shown in Table 1. The molar absorption coefficients are those determined from FT-IR measurement data of low molecular model compounds.

[Table 1]

Table 1

| Functional Group | Absorption Frequency ($cm^{-1}$) | Molar Extinction Coefficient (l/cm/mol) | Correction Factor | Model Compound |
|---|---|---|---|---|
| -COF | 1883 | 600 | 388 | $C_7F_{15}COF$ |
| -COOH free | 1815 | 530 | 439 | $H(CF_2)_6COOH$ |
| -COOH bonded | 1779 | 530 | 439 | $H(CF_2)_6COOH$ |
| $-COOCH_3$ | 1795 | 680 | 342 | $C_7F_{15}COOCH_3$ |
| $-CONH_2$ | 3436 | 506 | 460 | $C_7H_{15}CONH_2$ |
| $-CH_2OH_2$, -OH | 3648 | 104 | 2236 | $C_7H_{15}CH_2OH$ |
| $-CF_2H$ | 3020 | 8.8 | 26485 | $H(CF_2CF_2)_3CH_2OH$ |
| $-CF=CF_2$ | 1795 | 635 | 366 | $CF_2=CF_2$ |

The absorption frequencies of $-CH_2CF_2H$, $-CH_2COF$, $-CH_2COOH$, $-CH_2COOCH_3$ and $-CH_2CONH_2$ are lower by a few tens of kaysers ($cm^{-1}$) than those of $-CF_2H$, -COF, -COOH free and -COOH bonded, $-COOCH_3$ and $-CONH_2$ shown in the table, respectively.

Accordingly, the number of functional groups -COF, for example, is the total of the number of functional groups determined from an absorption peak having an absorption frequency of 1,883 $cm^{-1}$ derived from $-CF_2COF$ and the number of functional groups determined from an absorption peak having an absorption frequency of 1,840 $cm^{-1}$ derived from $-CH_2COF$.

The number of functional groups may be the total number of $-CF=CF_2$, $-CF_2H$, -COF, -COOH, $-COOCH_3$, $-CONH_2$, and $-CH_2OH$, and the number of functional groups may be the total number of $-CF_2H$, -COF, -COOH, $-COOCH_3$, and $-CH_2OH$.

The functional group is introduced into the perfluoropolymer compound X by, for example, a chain transfer agent or a polymerization initiator used when producing the perfluoropolymer compound X. For example, in the case of using an alcohol as a chain transfer agent, or a peroxide having a structure of $-CH_2OH$ as a polymerization initiator, $-CH_2OH$ is introduced to the main-chain terminal of the perfluoropolymer compound X. Alternatively, the functional group is introduced to the side-chain terminal of the perfluoropolymer compound X by polymerizing a monomer having the functional group. The perfluoropolymer compound X may contain a unit derived from a monomer having the functional group.

Examples of the monomer having a functional group include cyclic hydrocarbon monomers having a dicarboxylic acid anhydride group ((-CO-O-CO-) and having a polymerizable unsaturated group within the ring as described in Japanese Patent Laid-Open No. 2006-152234, and monomers having a functional group (f) as described in International Publication No. WO 2017/122743. Examples of the monomer having a functional group include, in particular, monomers having a carboxyl group (such as maleic acid, itaconic acid, citraconic acid, and undecylenic acid); monomers having an acid anhydride group (such as itaconic anhydride, citraconic anhydride, 5-norbornene-2,3-dicarboxylic anhydride, and maleic anhydride); and monomers having a hydroxyl group or an epoxy group (such as hydroxybutyl vinyl ether and glycidyl vinyl ether).

The perfluoropolymer compound X can be produced by a conventionally known method involving, for example, suitably mixing a monomer serving as its constituent unit and an additive such as a polymerization initiator, and performing

emulsion polymerization or suspension polymerization.

(Neutralized product of methacrylate resin)

The electrodeposition coating material composition of the present disclosure contains a neutralized product of a methacrylate resin. The methacrylate resin is preferably a depolymerizable methacrylate resin. In the present disclosure, depolymerization means that the polymer forming the resin decomposes to a monomer by being heated.

The neutralized product of a methacrylate resin in the electrodeposition coating material composition exhibits emulsifying ability by forming ions in water, forms emulsion particles together with the perfluoropolymer compound X even without a surfactant or the like, thus stably disperses in water, and can yield an electrodeposition coating material composition. Also, the neutralized product of a methacrylate resin imparts anionic properties to the perfluoropolymer compound X, and facilitates electrodeposition of the perfluoropolymer compound X. Moreover, when the methacrylate resin is a depolymerizable methacrylate resin, the neutralized product of the depolymerizable methacrylate resin is gradually depolymerized by being heated during film formation, thus helping to form a crack-free film. After the formation of the film is complete, much of the depolymerizable methacrylate resin is depolymerized, and only a portion of the depolymerizable methacrylate resin remains in the film. The neutralized product of the depolymerizable methacrylate resin less likely remains in the film than the neutralized product of a non-depolymerizable methacrylate resin, thus facilitates formation of a crack-free film and, moreover, does not significantly reduce the relative dielectric constant of the film. The use of the neutralized product of a non-depolymerizable methacrylate resin may possibly make it difficult to obtain a crack-free film.

Moreover, in the present disclosure, a methacrylate resin having an acid value of 10 mgKOH/g or more is used. The acid value of the methacrylate resin is preferably 15 mgKOH/g or more, more preferably 20 mgKOH/g or more, even more preferably 25 mgKOH/g or more, and particularly preferably 30 mgKOH/g or more. The upper limit of the acid value of the methacrylate resin is, for example, 150 mgKOH/g or less. The use of a methacrylate resin having an acid value within the above range makes it possible, without using a material such as a surfactant containing a metal component, to easily prepare an electrodeposition coating material composition, impart anionic properties to the perfluoropolymer compound X, and obtain a crack-free film.

The acid value of the methacrylate resin is the acid value of the methacrylate resin before being neutralized. The acid value of the methacrylate resin can be measured using potentiometric titration in accordance with JIS K 5601. For example, the methacrylate resin is dissolved in a mixed solvent of xylene and isopropyl alcohol and then titrated with a 0.1 mol/L potassium hydroxide/ethanol solution by potentiometric titration to determine the inflection point on the titration curve as an end point, and the acid value can be calculated from the titer of the potassium hydroxide solution to the end point. The acid value of the methacrylate resin can also be determined by calculation from the monomeric composition of the methacrylate resin.

The neutralized product of the methacrylate resin in one embodiment has an acid group, the number of which is to an extent such that the above acid value is imparted to the methacrylate resin, and which is neutralized by an alkali compound. The acid group is, for example, a carboxyl group, and the alkali compound is, for example, an amine compound.

The methacrylate resin can contain, for example, a (meth)acrylic acid ester unit, a hydroxyl group-containing (meth)acrylic acid ester unit, or an unsaturated carboxylic acid unit. In the present disclosure, "(meth)acrylic acid" means acrylic acid or methacrylic acid.

The methacrylate resin in one embodiment contains a (meth)acrylic acid ester unit and an unsaturated carboxylic acid unit. The methacrylate resin in one embodiment contains a (meth)acrylic acid ester unit, a hydroxyl group-containing (meth)acrylic acid ester unit, and an unsaturated carboxylic acid unit.

Examples of the (meth)acrylic acid ester include (meth)acrylic acid alkyl esters such as methyl acrylate, ethyl acrylate, n-propyl acrylate, isopropyl acrylate, n-butyl acrylate, methyl methacrylate, n-propyl methacrylate, ethyl methacrylate, n-butyl methacrylate, isopropyl methacrylate, 2-ethylhexyl acrylate, 2-ethylhexyl methacrylate, cyclohexyl acrylate, and cyclohexyl methacrylate. The (meth)acrylic acid ester, in particular, is preferably at least one selected from the group consisting of methyl methacrylate, n-butyl methacrylate, and n-butyl acrylate.

Examples of the hydroxyl group-containing (meth)acrylic acid ester include 2-hydroxyethyl methacrylate, 2-hydroxyethyl acrylate, 3-hydroxypropyl methacrylate, 3-hydroxypropyl acrylate, 2-hydroxypropyl methacrylate, 2-hydroxypropyl acrylate, 4-hydroxybutyl acrylate, 4-hydroxybutyl methacrylate, 2-hydroxybutyl acrylate, 2-hydroxybutyl methacrylate, 6-hydroxyhexyl acrylate, and 6-hydroxyhexyl methacrylate. The hydroxyl group-containing (meth)acrylic acid ester, in particular, is preferably at least one selected from the group consisting of 2-hydroxyethyl methacrylate and 2-hydroxyethyl acrylate.

The (meth)acrylic acid ester unit and the hydroxyl group-containing (meth)acrylic acid ester unit regulate the glass transition temperature of the neutralized product of the methacrylate resin, and impart suitable film-formability to the electrodeposition coating material composition. The contents of the (meth)acrylic acid ester unit and the hydroxyl group-containing (meth)acrylic acid ester unit are regulated such that, for example, suitable film-formability required for the electrodeposition coating material composition is imparted.

Examples of the unsaturated carboxylic acid include acrylic acid, methacrylic acid, vinyl acetic acid, crotonic acid, cinnamic acid, 3-allyloxypropionic acid, 3-(2-allyloxyethoxycarbonyl)propionic acid, itaconic acid, itaconic acid monoester, maleic acid, maleic acid monoester, maleic anhydride, fumaric acid, fumaric acid monoester, vinyl phthalate, vinyl pyromellitate, and undecylenic acid. The unsaturated carboxylic acid, in particular, is preferably at least one selected from the group consisting of acrylic acid and methacrylic acid.

The unsaturated carboxylic acid unit imparts a suitable acid value to the methacrylate resin. The content of the unsaturated carboxylic acid unit is regulated, for example, to impart the methacrylate resin an acid value within the above range.

The methacrylate resin in one embodiment has a carboxyl group and, preferably, contains an unsaturated carboxylic acid unit. When the methacrylate resin has a carboxyl group, the neutralized product of the methacrylate resin is preferably a neutralized product obtained by neutralizing the methacrylate resin having a carboxyl group with an amine compound. When the neutralized product of the methacrylate resin is what is obtained by neutralizing a methacrylate resin having a carboxy group with an amine compound, it is possible, without using a material such as a surfactant containing a metal component, to more easily prepare an electrodeposition coating material composition, and more easily obtain a crack-free film. Moreover, the emulsifying ability of the neutralized product of the methacrylate resin is also improved and, therefore, when preparing the electrodeposition coating material composition by phase inversion emulsification, which will be described below, the perfluoropolymer compound X can be extremely stably dispersed in an aqueous dispersion, and the electrodeposition coating material composition can be prepared more easily without using a material such as a surfactant containing a metal component.

The amine compound used to neutralize the methacrylate resin having a carboxyl group may be any of a primary amine, a secondary amine, and a tertiary amine, and is preferably a tertiary amine. The amine compound is preferably an aliphatic amine, and is preferably at least one selected from the group consisting of ethylamine, diethylamine, diethylpropylamine, triethylamine, propylamine, dipropylamine, tripropylamine, butylamine, dibutylamine, tributylamine, monoethanolamine, diethanolamine, triethanolamine, dimethylethanolamine, and diethylethanolamine. The amine compound, in particular, is preferably triethylamine.

The amount of the amine compound to be used is determined by the desired degree of neutralization of the neutralized product of the methacrylate resin. The degree of neutralization of the neutralized product of the methacrylate resin is preferably 50% or more, more preferably 60% or more, and even more preferably 70% or more, and is preferably 95% or less and more preferably 90% or less. When the degree of neutralization of the neutralized product of the methacrylate resin is within the above range, it is possible, without using a material such as a surfactant containing a metal component, to more easily prepare an electrodeposition coating material composition, and more easily obtain a crack-free film. Moreover, the emulsifying ability of the neutralized product of the methacrylate resin is also improved and, therefore, when preparing the electrodeposition coating material composition by phase inversion emulsification, which will be described below, the perfluoropolymer compound X can be extremely stably dispersed in an aqueous dispersion, and the electrodeposition coating material composition can be prepared more easily without using a material such as a surfactant containing a metal component.

The degree of neutralization of the neutralized product of the methacrylate resin can be measured by dividing the amine value measured by potentiometric titration by the acid value. For example, the degree of neutralization can be calculated by adding tetrahydrofuran to the methacrylate resin, then titrating to the equivalence point with a 0.1 mol/L hydrochloric acid solution by potentiometric titration to determine the inflection point on the titration curve as an amine value, and dividing the amine value by the acid value. The degree of neutralization of the neutralized product of the methacrylate resin can also be obtained by calculation from the monomeric composition of the methacrylate resin and the amount of the compound, such as an amine compound, used in neutralization.

The neutralized product of the methacrylate resin is preferably obtained by, for example, neutralizing a methacrylate resin containing an unsaturated carboxylic acid unit in a content that imparts an acid value within the above range with an amine compound used in an amount that provides a degree of neutralization within the above range.

(Electrodeposition coating material composition)

The electrodeposition coating material composition of the present disclosure can be produced by a production method involving adding a water dispersion composition containing the perfluoropolymer compound X and water to a solution containing the neutralized product of the methacrylate resin and an organic solvent, and subjecting the mixture to phase inversion emulsification. The use of the electrodeposition coating material composition obtained by such a production method enables a crack-free film to be more easily obtained.

The organic solvent of the solution containing the neutralized product of the methacrylate resin is preferably an organic solvent capable of dissolving the neutralized product of the methacrylate resin. Examples of the organic solvent

include alcohols such as methanol, ethanol, isopropyl alcohol, and n-butanol; ketones such as acetone, methyl ethyl ketone, methyl isobutyl ketone, and diethyl ketone; ethers such as dibutyl ether, tetrahydrofuran, and dioxane; and acetic acid esters such as ethyl acetate and isopropyl acetate.

Phase inversion emulsification can be performed by, for example, adding the water dispersion composition to the solution while stirring the solution. The temperatures of the solution and the water dispersion composition may be ordinary temperature (e.g., 10 to 40°C).

The electrodeposition coating material composition contains the perfluoropolymer compound X and the neutralized product of the methacrylate resin, and preferably further contains water.

The electrodeposition coating material composition contains the perfluoropolymer compound X and the neutralized product of the methacrylate resin, and preferably further contains an organic solvent. Examples of the organic solvent include those described above as organic solvents for the solution containing the neutralized product of the methacrylate resin.

From the viewpoint of efficiently forming the film by electrodeposition coating, the solid concentration of the electrodeposition coating material composition is preferably 10 to 70% by mass, more preferably 50% by mass or less, and even more preferably 30% by mass or less.

The mass ratio of the perfluoropolymer compound X to the neutralized product of the methacrylate resin in the electrodeposition coating material composition is preferably 10/90 to 90/10, more preferably 20/80 or more, and even more preferably 25/75 or more, and is more preferably 80/20 or less and even more preferably 75/25 or less.

The alkali metal content in the electrodeposition coating material composition is preferably less than 1 mass ppm. The electrodeposition coating material composition of the present disclosure can be prepared without using a material that contains a metal component and, therefore, the alkali metal content can be lower than that of conventional electrodeposition coating material compositions.

The alkali metal content in the electrodeposition coating material composition can be measured by inductively coupled plasma mass spectrometry.

The electrodeposition coating material composition of the present disclosure may contain an additive in order to, for example, improve coatability and the properties of the resulting film.

The electrodeposition coating material composition of the present disclosure can be suitably used as an anionic electrodeposition coating material composition.

(Fluorine-containing compound having hydrophilic group)

In one embodiment, an electrodeposition coating material composition having a reduced content of a fluorine-containing compound having a hydrophilic group can be used. By reducing the content of the fluorine-containing compound having a hydrophilic group in the electrodeposition coating material composition, a film having a large contact angle and a small coefficient of friction can be obtained. While the reason therefor is not clear, it is conjectured that when the content of the fluorine-containing compound having a hydrophilic group in the electrodeposition coating material composition is reduced, the dispersion stability of the perfluoropolymer compound X in the electrodeposition coating material composition is appropriately low, accordingly the perfluoropolymer compound X, when forming a film, is more likely to rise to the surface of the film than other components, and, as a result, the proportion of the perfluoropolymer compound X on the film surface is increased.

The fluorine-containing compound having a hydrophilic group includes a fluorine-containing surfactant added during polymerization and a fluorine-containing compound having a hydrophilic group produced by polymerization of a fluoromonomer.

The hydrophilic group contained in the fluorine-containing compound is preferably an anionic group such as an acid group, and examples include $-NH_2$, $-PO_3M$, $-OPO_3M$, $-SO_3M$, $-OSO_3M$, and -COOM (in each formula, M represents a cation). The hydrophilic group, in particular, is preferably $-SO_3M$ or -COOM, and more preferably -COOM.

The content of the fluorine-containing compound having a hydrophilic group in the electrodeposition coating material composition is preferably 50 mass ppb or less and more preferably 45 mass ppb or less, and is preferably more than 0 mass ppb, based on the perfluoropolymer compound X.

The content of the fluorine-containing compound having a hydrophilic group in the electrodeposition coating material composition can be quantified by a known method. For example, it can be quantified by LC/MS analysis.

First, methanol is added to the electrodeposition coating material composition to perform extraction, and the resulting extract is subjected to LC/MS analysis. To further increase extraction efficiency, treatment by Soxhlet extraction, ultrasonic treatment, or the like may be performed. The resulting extract is suitably concentrated under nitrogen purge, and the fluorine-containing compound in the concentrated extract is measured by LC/MS.

From the resulting LC/MS spectrum, the molecular weight information is extracted to confirm agreement with the structural formula of the candidate fluorine-containing compound having a hydrophilic group.

Thereafter, aqueous solutions having five or more different content levels of the confirmed fluorine-containing

compound having a hydrophilic group are prepared, and LC/MS analysis is performed on the aqueous solutions with the respective content levels, and the relationship between the content level and the area corresponding to that content level is plotted to draw a calibration curve.

Then, using the calibration curve, the areal size of the LC/MS chromatogram of the fluorine-containing compound having a hydrophilic group in the extract can be converted to the content of the fluorine-containing compound having a hydrophilic group.

The resulting extract can be concentrated by nitrogen purge, and thus the lower limit of quantification of the measurement method can be lowered.

The electrodeposition coating material composition in one embodiment contains at least a fluorine-containing surfactant as a fluorine-containing compound having a hydrophilic group. The fluorine-containing surfactant may be a fluorine-containing surfactant commonly used when polymerizing a fluoromonomer. A typical compound as a fluorine-containing surfactant is a fluorine-containing surfactant having a molecular weight of 1,000 g/mol or less, and preferably 800 g/mol or less.

The fluorine-containing surfactant is not limited as long as it is a surfactant containing at least one fluorine atom, and conventionally known fluorine-containing surfactants can be used.

Examples of the fluorine-containing surfactant include anionic fluorine-containing surfactants. The anionic fluorine-containing surfactant may be, for example, a fluorine atom-containing surfactant having 20 or fewer carbon atoms in total in the portion excluding the anionic group.

The fluorine-containing surfactant may also be a fluorine-containing surfactant in which the molecular weight of the anionic moiety is 1,000 or less.

The "anionic moiety" means a portion of the fluorine-containing surfactant excluding the cation. For example, in the case of $F(CF_2)_{n1}COOM$ represented by the formula (I) below, the anionic moiety is the "$F(CF_2)_{n1}COO$" portion.

The fluorine-containing surfactant may also be a fluorine-containing surfactant having a LogPOW of 3.5 or less. The LogPOW is a partition coefficient between 1-octanol and water, and is represented by LogP wherein P represents a ratio of the fluorine-containing surfactant concentration in octanol/the fluorine-containing surfactant concentration in water attained when an octanol/water (1:1) mixture containing the fluorine-containing surfactant is phase-separated.

The LogPOW is calculated by performing HPLC on standard substances (heptanoic acid, octanoic acid, nonanoic acid, and decanoic acid) having a known octanol/water partition coefficient under conditions having column: TOSOH ODS-120T column (φ4.6 mm × 250 mm, manufactured by Tosoh Corporation), eluent: acetonitrile/0.6 mass% $HClO_4$ aqueous solution = 1/1 (vol/vol%), flow rate: 1.0 ml/min, sample volume: 300 μL, column temperature: 40°C, detection light: UV210 nm to construct a calibration curve concerning each elution time and known octanol/water partition coefficient, and determining the HPLC elution time of a sample liquid based on the calibration curve.

Specific examples of the fluorine-containing surfactant include those described in U.S. Patent Application Publication No. 2007/0015864, U.S. Patent Application Publication No. 2007/0015865, U.S. Patent Application Publication No. 2007/0015866, U.S. Patent Application Publication No. 2007/0276103, U.S. Patent Application Publication No. 2007/0117914, U.S. Patent Application Publication No. 2007/142541, U.S. Patent Application Publication No. 2008/0015319, U.S. Patent. No. 3250808, U.S. Patent. No. 3271341, Japanese Patent Laid-Open No. 2003-119204, International Publication No. WO 2005/042593, International Publication No. WO 2008/060461, International Publication No. WO 2007/046377, Japanese Patent Laid-Open No. 2007-119526, International Publication No. WO 2007/046482, International Publication No. WO 2007/046345, U.S. Patent Application Publication No. 2014/0228531, International Publication No. WO 2013/189824, and International Publication No. WO 2013/189826.

The anionic fluorine-containing surfactant may be a compound represented by the following general formula ($N^0$):

$$X^{n0}\text{-}Rf^{n0}\text{-}Y^0 \qquad (N^0)$$

wherein $X^{n0}$ is H, Cl, or F; $Rf^{n0}$ is a linear, branched, or cyclic alkylene group having 3 to 20 carbon atoms in which some or all H atoms are replaced with F, where the alkylene group may contain one or more ether bonds and some H atoms may be replaced with Cl; and $Y^0$ is an anionic group.

The anionic group $Y^0$ may be $-COOM$, $-SO_2M$, or $-SO_3M$, and may be $-COOM$ or $-SO_3M$.

M is H, a metal atom, $NR^7_4$, optionally substituted imidazolium, optionally substituted pyridinium, or optionally substituted phosphonium, and $R^7$ is H or an organic group.

Examples of the metal atom include alkali metals (Group 1) and alkaline earth metals (Group 2), such as Na, K, or Li.

$R^7$ may be H or a $C_{1-10}$ organic group, may be H or a $C_{1-4}$ organic group, and may be H or a $C_{1-4}$ alkyl group.

M may be H, a metal atom, or $NR^7_4$, may be H, an alkali metal (Group 1), an alkaline earth metal (Group 2), or $NR^7_4$, and may be H, Na, K, Li, or $NH_4$.

In $Rf^{n0}$, 50% or more H atoms may be replaced with fluorine.

Specific examples of the compound represented by general formula ($N^0$) include perfluorocarboxylic acid (I) represented by the following general formula (I), ω-H perfluorocarboxylic acid (II) represented by the following general formula (II), perfluoroether carboxylic acid (III) represented by the following general formula (III), perfluoroalkylalkylenecarboxylic acid (IV) represented by the following general formula (IV), perfluoroalkoxyfluorocarboxylic acid (V) represented by the following general formula (V), perfluoroalkylsulfonic acid (VI) represented by the following general formula (VI), ω-H perfluorosulfonic acid (VII) represented by the following general formula (VII), perfluoroalkylalkylene sulfonic acid (VIII) represented by the following general formula (VIII), alkylalkylenecarboxylic acid (IX) represented by the following general formula (IX), fluorocarboxylic acid (X) represented by the following general formula (X), alkoxyfluorosulfonic acid (XI) represented by the following general formula (XI), compound (XII) represented by the following general formula (XII), and compound (XIII) represented by the following general formula (XIII).

The perfluorocarboxylic acid (I) is represented by the following general formula (I):

$$F(CF_2)_{n1}COOM \qquad (I)$$

wherein n1 is an integer of 3 to 13, M is H, a metal atom, $NR^7_4$, an optionally substituted imidazolium, optionally substituted pyridinium, or optionally substituted phosphonium, and $R^7$ is H or an organic group.

The ω-H perfluorocarboxylic acid (II) is represented by the following general formula (II):

$$H(CF_2)_{n2}COOM \qquad (II)$$

wherein n2 is an integer of 4 to 15, and M is as defined above.

The perfluoroethercarboxylic acid (III) is represented by the following general formula (III):

$$Rf^1\text{-}O\text{-}(CF(CF_3)CF_2O)_{n3}CF(CF_3)COOM \qquad (III)$$

wherein $Rf^1$ is a perfluoroalkyl group having 1 to 5 carbon atoms, n3 is an integer of 0 to 3, and M is as defined above.

The perfluoroalkylalkylenecarboxylic acid (IV) is represented by the following general formula (IV):

$$Rf^2(CH_2)_{n4}Rf^3COOM \qquad (IV)$$

wherein $Rf^2$ is a perfluoroalkyl group having 1 to 5 carbon atoms, $Rf^3$ is a linear or branched perfluoroalkylene group having 1 to 3 carbon atoms, n4 is an integer of 1 to 3, and M is as defined above.

The alkoxyfluorocarboxylic acid (V) is represented by the following general formula (V):

$$Rf^4\text{-}O\text{-}CY^1Y^2CF_2\text{-}COOM \qquad (V)$$

wherein $Rf^4$ is a linear or branched, partially or fully fluorinated alkyl group having 1 to 12 carbon atoms and optionally containing an ether bond and/or a chlorine atom, $Y^1$ and $Y^2$ are the same or different and are H or F, and M is as defined above.

The perfluoroalkylsulfonic acid (VI) is represented by the following general formula (VI):

$$F(CF_2)_{n5}SO_3M \qquad (VI)$$

wherein n5 is an integer of 3 to 14, and M is as defined above.

The ω-H perfluorosulfonic acid (VII) is represented by the following general formula (VII):

$$H(CF_2)_{n6}SO_3M \qquad (VII)$$

wherein n6 is an integer of 4 to 14, and M is as defined above.

The perfluoroalkylalkylenesulfonic acid (VIII) is represented by the following general formula (VIII):

$$Rf^5(CH_2)_{n7}SO_3M \qquad (VIII)$$

wherein $Rf^5$ is a perfluoroalkyl group having 1 to 13 carbon atoms, n7 is an integer of 1 to 3, and M is as defined above.

The alkylalkylenecarboxylic acid (IX) is represented by the following general formula (IX):

$$Rf^6(CH_2)_{n8}COOM \qquad (IX)$$

wherein $Rf^6$ is a linear or branched, partially or fully fluorinated alkyl group having 1 to 13 carbon atoms and optionally containing an ether bond, n8 is an integer of 1 to 3, and M is as defined above.

The fluorocarboxylic acid (X) is represented by the following general formula (X):

$$Rf^7\text{-O-}Rf^8\text{-O-}CF_2\text{-COOM} \qquad (X)$$

wherein $Rf^7$ is a linear or branched partially or fully fluorinated alkyl group having 1 to 6 carbon atoms and optionally containing an ether bond and/or a chlorine atom; $Rf^8$ is a linear or branched partially or fully fluorinated alkyl group having 1 to 6 carbon atoms; and M is as defined above.

The alkoxyfluorosulfonic acid (XI) is represented by the following general formula (XI):

$$Rf^9\text{-O-}CY^1Y^2CF_2\text{-}SO_3M \qquad (XI)$$

wherein $Rf^9$ is a linear or branched, partially or fully fluorinated alkyl group having 1 to 12 carbon atoms, optionally containing chlorine, and optionally containing an ether bond, $Y^1$ and $Y^2$ are the same or different and are H or F, and M is as defined above.

The compound (XII) is represented by the following general formula (XII):

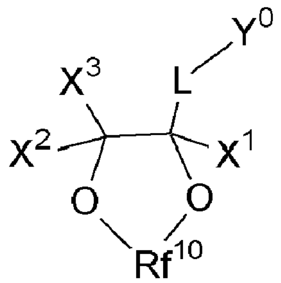

(XII)

wherein $X^1$, $X^2$, and $X^3$ may be the same or different and are H, F, or a linear or branched partially or fully fluorinated alkyl group having 1 to 6 carbon atoms and optionally containing an ether bond; $Rf^{10}$ is a perfluoroalkylene group having 1 to 3 carbon atoms; L is a linking group; and $Y^0$ is an anionic group.

$Y^0$ may be -COOM, $-SO_2M$, or $-SO_3M$, and may be $-SO_3M$ or COOM, wherein M is as defined above.

Examples of L include a single bond, and a partially or fully fluorinated alkylene group having 1 to 10 carbon atoms and optionally containing an ether bond.

The compound (XIII) is represented by the following general formula (XIII):

$$Rf^{11}\text{-O-}(CF_2CF(CF_3)O)_{n9}(CF_2O)_{n10}CF_2COOM \qquad (XIII)$$

wherein $Rf^{11}$ is a fluoroalkyl group having 1 to 5 carbon atoms and containing chlorine, n9 is an integer of 0 to 3, n10 is an integer of 0 to 3, and M is as defined above. Examples of the compound (XIII) include $CF_2ClO\ (CF_2CF(CF_3)O)_{n9}(CF_2O)_{n10}CF_2COONH_4$ (a mixture having an average molecular weight of 750, wherein n9 and n10 are as defined above).

As described above, examples of the anionic fluorine-containing surfactant include a carboxylic acid-based surfactant and a sulfonic acid-based surfactant.

The fluorine-containing surfactant may be one fluorine-containing surfactant, or may be a mixture containing two or more fluorine-containing surfactants.

The fluorine-containing surfactant preferably does not have a methylene group ($-CH_2-$), and more preferably does not have a C-H bond.

The number of H atoms that the hydrophobic group of the fluorine-containing surfactant has is preferably 0 or 1, and more preferably 0. The number of carbon atoms in the hydrophobic group of the fluorine-containing surfactant having a hydrophobic group and a hydrophilic group is preferably 1 to 50, more preferably 3 to 20, and even more preferably 6 to 12. The hydrophobic group usually constitutes the above-described "portion excluding the anionic group" in the molecular structure of the fluorine-containing surfactant. Examples of the hydrophilic group include groups exemplified as the anionic group $Y^0$. The fluorine-containing surfactant may be a saturated fluorinated surfactant in which all carbon atoms bonded to the hydrophobic group are substituted with fluorine atoms.

Examples of fluorine-containing surfactants, among the above-described anionic fluorine-containing surfactants, include compounds represented by general formula ($N^1$), compounds represented by general formula ($N^2$), and compounds represented by general formula ($N^4$):

$Rf^{n4}$-O-$(CY^{n1}F)_pCF_2$-$Y^0$ (N4)

wherein $Rf^{n4}$ is a linear or branched, partially or fully fluorinated alkyl group having 1 to 12 carbon atoms and optionally containing an ether bond (provided that those having $-CH_2-$ are excluded), $Y^{n1}$ is H or F, p is 0 or 1, and $Y^0$ is as defined above; and compounds represented by general formula ($N^5$):

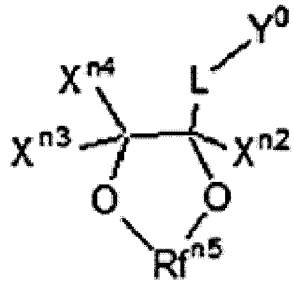

(N5)

wherein $X^{n2}$, $X^{n3}$, and $X^{n4}$ may be the same or different and are each independently H, F, or a linear or branched, partially or fully fluorinated alkyl group having 1 to 6 carbon atoms and optionally containing an ether bond (provided that those having $-CH_2-$ are excluded), provided that $X^{n3}$ and $X^{n4}$ are not simultaneously H; $Rf^{n5}$ is a linear or branched, partially or fully fluorinated alkylene group having 1 to 3 carbon atoms and optionally containing an ether bond (provided that those having $-CH_2-$ are excluded); L is a linking group; and $Y^0$ is as defined above, provided that the total number of carbon atoms of $X^{n2}$, $X^{n3}$, $X^{n4}$, and $Rf^{n5}$ is 18 or less.

Among the above-described anionic fluorine-containing surfactants, the fluorine-containing surfactant is preferably at least one selected from the group consisting of perfluorocarboxylic acid (I) represented by general formula (I), ω-H perfluorocarboxylic acid (II) represented by general formula (II), perfluoroethercarboxylic acid (III) represented by general formula (III), perfluoroalkylalkylenecarboxylic acid (IV) represented by general formula (IV), perfluoroalkoxyfluorocarboxylic acid (V) represented by general formula (V), perfluoroalkylsulfonic acid (VI) represented by general formula (VI), ω-H perfluorosulfonic acid (VII) represented by general formula (VII), perfluoroalkylalkylenesulfonic acid (VIII) represented by general formula (VIII), fluorocarboxylic acid (X) represented by general formula (X): $Rf^7$-O-$Rf^8$-O-$CF_2$-COOM

wherein $Rf^7$ is a linear or branched, partially or fully fluorinated alkyl group having 1 to 6 carbon atoms and optionally containing an ether bond and/or a chlorine atom (provided that those having $-CH_2-$ are excluded), $Rf^8$ is a linear or branched, partially or fully fluorinated alkyl group having 1 to 6 carbon atoms (provided that those having $-CH_2-$are excluded), and M is as defined above, an alkoxyfluorosulfonic acid (XI) represented by general formula (XI): $Rf^9$-O-$CY^1FCF_2$-$SO_3M$

wherein $Rf^9$ is a linear or branched, partially or fully fluorinated alkyl group having 1 to 12 carbon atoms, optionally containing chlorine, and optionally containing an ether bond (provided that those having $-CH_2-$ are excluded), $Y^1$ is H or F, and M is as defined above, a compound (XII) represented by general formula (XII):

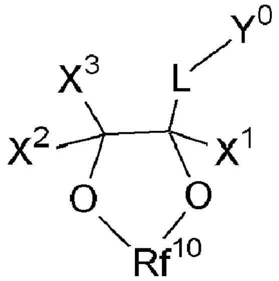

(XII)

wherein $X^1$, $X^2$, and $X^3$ may be the same or different and are each independently H, F, and a linear or branched, partially or fully fluorinated alkyl group having 1 to 6 carbon atoms and optionally containing an ether bond (provided that those having $-CH_2-$ are excluded), provided that $X^2$ and $X^3$ are not simultaneously H, $Rf^{10}$ is a perfluoroalkylene group having 1 to 3 carbon atoms, L is a linking group, and $Y^0$ is an anionic group, and

a compound (XIII) represented by general formula (XIII): $Rf^{11}$-O-$(CF_2CF(CF_3)O)_{n9}(CF_2O)_{n10}CF_2COOM$

wherein $Rf^{11}$ is a fluoroalkyl group having 1 to 5 carbon atoms containing chlorine (provided that those having $-CH_2-$ are excluded), n9 is an integer of 0 to 3, n10 is an integer of 0 to 3, and M is as defined above.

When the electrodeposition coating material composition contains at least a fluorine-containing surfactant as a fluorine-containing compound having a hydrophilic group, the content of the fluorine-containing surfactant in the electrodeposition coating material composition is preferably 50 mass ppb or less and more preferably 45 mass ppb or less, and is preferably more than 0 mass ppb, based on the perfluoropolymer compound X.

The electrodeposition coating material composition in one embodiment contains perfluoroether carboxylic acid as a fluorine-containing compound having a hydrophilic group. The perfluoroether carboxylic acid is preferably a compound (III) represented by the following general formula (III):

General formula (III): $Rf^1\text{-O-}(CF(CF_3)CF_2O)_{n3}CF(CF_3)COOM$

wherein $Rf^1$ is a perfluoroalkyl group having 1 to 5 carbon atoms, n3 is an integer of 0 to 3, M is H, a metal atom, $NR^7_4$, an optionally substituted imidazolium, optionally substituted pyridinium, or optionally substituted phosphonium, and $R^7$ is H or an organic group.

When the electrodeposition coating material composition contains at least perfluoroether carboxylic acid as a fluorine-containing compound having a hydrophilic group, the content of the perfluoroether carboxylic acid in the electrodeposition coating material composition is preferably 50 mass ppb or less and more preferably 45 mass ppb or less, and is preferably more than 0 mass ppb, based on the perfluoropolymer compound X.

The electrodeposition coating material composition in one embodiment contains a compound represented by the following general formula (H1) as a fluorine-containing compound having a hydrophilic group:

General formula (H1): $[X\text{-Rf-}A^-]_iM^{i+}$

wherein X is H, Cl, Br, F, or I; Rf is a linear or branched, partially fluorinated or fully fluorinated aliphatic group, or a linear or branched, partially fluorinated or fully fluorinated aliphatic group interrupted by at least one oxygen atom; $A^-$ is an acid group; $M^{i+}$ is a cation having a valence of i; and i represents an integer of 1 to 3.

The electrodeposition coating material composition in one embodiment contains a compound represented by the following general formula (H2) as a fluorine-containing compound having a hydrophilic group:

General formula (H2): $[C_{n-1}F_{2n-1}COO^-]M^+$

wherein n is an integer of 4 to 14, and $M^+$ represents a cation.

The compound represented by the general formula (H2) (perfluoroalkanoic acid) is known to be formed during polymerization when perfluoroalkyl vinyl ether or the like is used as a modifying monomer (see International Publication No. WO 2019/161153).

When the electrodeposition coating material composition contains at least a compound represented by the general formula (H2) as a fluorine-containing compound having a hydrophilic group, the content of the compound represented by the general formula (H2) in the electrodeposition coating material composition is preferably 50 mass ppb or less and more preferably 45 mass ppb or less, and is preferably more than 0 mass ppb, based on the perfluoropolymer compound X.

The electrodeposition coating material composition in one embodiment contains a compound represented by the following general formula (H3) as a fluorine-containing compound having a hydrophilic group:

General formula (H3): $[R^1\text{-O-L-}CO_2^-]M^+$

wherein $R^1$ is a linear or branched, partially fluorinated or fully fluorinated aliphatic group, or a linear or branched, partially fluorinated or fully fluorinated aliphatic group interrupted by at least one oxygen atom; L represents a linear or branched non-fluorinated, partially fluorinated, or fully fluorinated alkylene group; and $M^+$ represents a cation.

When the electrodeposition coating material composition contains at least a compound represented by the general formula (H3) as a fluorine-containing compound having a hydrophilic group, the content of the compound represented by the general formula (H3) in the electrodeposition coating material composition is preferably 50 mass ppb or less and more preferably 45 mass ppb or less, and is preferably more than 0 mass ppb, based on the perfluoropolymer compound X.

The electrodeposition coating material composition in one embodiment contains a compound represented by the general formula (H4) as a fluorine-containing compound having a hydrophilic group:

General formula (H4): $H\text{-}Rf^{n0}\text{-}Y^0$

wherein $Rf^{n0}$ is a linear, branched, or cyclic alkylene group having 3 to 20 carbon atoms in which some or all H atoms are

replaced with F; the alkylene group optionally containing one or more ether bonds in which some H atoms are replaced with Cl; and $Y^0$ is an anionic group.

Examples of the compound represented by the general formula (H4) include compounds represented by any of the following general formulae:

General formula: $[H-(CF_2)_mCO_2^-]M^+$

wherein m represents an integer of 3 to 19, and $M^+$ represents a cation; and

General formula: $[H- (CF_2)_{m2}-(CF(CF_3))_{m3}-CO_2^-]M^+$

wherein m2 represents an integer of 1 to 17, m3 represents an integer of 1 to 9, and $M^+$ represents a cation, provided that, m2 and m3 are selected so as to satisfy $3 \leq (m2 + 2 \times m3) \leq 19$, and each repeating unit occurs in any order in the formula.

When the electrodeposition coating material composition contains at least a compound represented by the general formula (H4) as a fluorine-containing compound having a hydrophilic group, the content of the compound represented by the general formula (H4) in the electrodeposition coating material composition is preferably 50 mass ppb or less and more preferably 45 mass ppb or less, and is preferably more than 0 mass ppb, based on the perfluoropolymer compound X.

The electrodeposition coating material composition having a reduced content of the fluorine-containing compound having a hydrophilic group is a water dispersion composition containing the perfluoropolymer compound X and water, and can be prepared by producing a water composition having a reduced content of the fluorine-containing compound having a hydrophilic group and using it as a raw material of the electrodeposition coating material composition.

The content of the fluorine-containing compound having a hydrophilic group in the water dispersion composition can be regulated by, for example, polymerizing a fluoromonomer in the presence of a fluorine-containing surfactant, a polymerization initiator, and an aqueous medium to prepare an aqueous dispersion containing the perfluoropolymer compound X and water, adding a relatively large amount of a radical generator to the aqueous dispersion, and heat-treating the mixture.

The water dispersion composition having a reduced content of the fluorine-containing compound having a hydrophilic group can be produced by, for example, a production method involving:

polymerizing a fluoromonomer in a reactor in the presence of a fluorine-containing surfactant, a polymerization initiator, and an aqueous medium to prepare an aqueous dispersion containing the perfluoropolymer compound X;
after the aqueous dispersion is prepared, performing at least one of the operations of removing from the reactor the fluoromonomer remaining in the reactor, and recovering the aqueous dispersion in the reactor to accommodate the aqueous dispersion in a container different from the reactor;
adding a radical generator to the aqueous dispersion in an amount corresponding to 5 mol or more per mole of the fluorine-containing surfactant used in the polymerization; and
heat-treating the aqueous dispersion comprising the radical generator.

(Polymerization of fluoromonomer)

In the above production method, first a fluoromonomer is polymerized in a reactor in the presence of a fluorine-containing surfactant, a polymerization initiator, and an aqueous medium to prepare an aqueous dispersion containing the perfluoropolymer compound X.

The polymerization of a fluoromonomer can be performed by charging a reactor with a fluoromonomer, a fluorine-containing surfactant, a polymerization initiator, an aqueous medium, and optionally other additives, stirring the contents of the reactor, retaining the reactor at a predetermined polymerization temperature, and then adding a predetermined amount of a polymerization initiator to initiate the polymerization reaction. After the polymerization reaction is initiated, the fluoromonomer, the polymerization initiator, the fluorine-containing surfactant, and a chain transfer agent may be further added depending on the purpose. The method for polymerizing the fluoromonomer is not limited, and is preferably an emulsion polymerization method.

(Fluorine-containing surfactant)

Examples of the fluorine-containing surfactant used in the polymerization of a fluoromonomer include fluorine-containing surfactants that can be contained in the electrodeposition coating material composition of the present disclosure, and such fluorine-containing surfactants can be preferably used.

The amount of the fluorine-containing surfactant added is preferably 10 mass ppm to 10% by mass, more

preferably 100 mass ppm or more, and even more preferably 300 mass ppm or more, and is more preferably 5% by mass or less and even more preferably 1% by mass or less, based on the aqueous medium.

(Polymerization initiator)

The polymerization initiator used in the polymerization of the fluoromonomer is not limited as long as it is a polymerization initiator capable of generating radicals within the polymerization temperature range, and known oil-soluble and/or water-soluble polymerization initiators can be used. The polymerization initiator can also be combined with a reducing agent or the like to form a redox agent and initiate polymerization. The concentration of the polymerization initiator is suitably determined according to the type of monomer, the molecular weight of the target perfluoropolymer compound X, and the reaction rate.

The polymerization initiator may be an oil-soluble radical polymerization initiator or a water-soluble radical polymerization initiator.

The oil-soluble radical polymerization initiator may be a known oil-soluble peroxide, and representative examples include dialkyl peroxycarbonates such as diisopropyl peroxydicarbonate and di-sec-butyl peroxydicarbonate; peroxy esters such as t-butyl peroxyisobutyrate and t-butyl peroxypivalate; and dialkyl peroxides such as di-t-butyl peroxide.

The water-soluble radical polymerization initiator may be a known water-soluble peroxide, and examples include ammonium salts, potassium salts, and sodium salts of persulphuric acid, perboric acid, perchloric acid, perphosphoric acid, and percarbonic acid, organic peroxides of disuccinic acid peroxide and diglutaric acid peroxide or the like, t-butyl permaleate, and t-butyl hydroperoxide. A reducing agent such as sulfite may be contained together, and may be used in an amount of 0.1 to 20 times the amount of the peroxide.

(Aqueous medium)

The aqueous medium for use in the polymerization of the fluoromonomer is a reaction medium in which the polymerization is performed, and means a liquid containing water. The aqueous medium is not limited as long as it contains water, and may be an aqueous medium containing water and, for example, a fluorine-free organic solvent such as ether or ketone, and/or a fluorine-containing organic solvent having a boiling point of 40°C or lower.

The aqueous medium is preferably an aqueous medium solely containing water or an aqueous medium solely containing water and a fluorine-free organic solvent, and is more preferably an aqueous medium solely containing water, because the polymerization of the fluoromonomer can proceed smoothly and, also, deterioration of the efficiency of removing the fluorine-containing compound having a hydrophilic group can be suppressed.

The water content in the aqueous medium is preferably 90% or more, more preferably 95% or more, even more preferably 99.0% or more, yet more preferably 99.5% or more, and particularly preferably 99.9% or more, and may be 100% based on the mass of the aqueous medium, because the polymerization of the fluoromonomer can proceed smoothly and, also, deterioration of the efficiency of removing the fluorine-containing compound having a hydrophilic group can be suppressed.

(Chain transfer agent)

In the above production method, the fluoromonomer can be polymerized also in the presence of a chain transfer agent. The use of a chain transfer agent enables the polymerization rate and the molecular weight to be regulated. Examples of the chain transfer agent include esters such as dimethyl malonate, diethyl malonate, methyl acetate, ethyl acetate, butyl acetate, and dimethyl succinate, as well as isopentane, methane, ethane, propane, methanol, isopropanol, acetone, various mercaptans, various halogenated hydrocarbons such as carbon tetrachloride, and cyclohexane.

The amount of the chain transfer agent used is usually 1 to 50,000 mass ppm, and preferably 1 to 20,000 mass ppm, based on the total amount of the fluoromonomer fed. The amount of the chain transfer agent used is preferably an amount such that the chain transfer agent is completely consumed during the polymerization of the fluoromonomer and does not remain in the aqueous dispersion containing the perfluoropolymer compound X so as not to deteriorate as much as possible the efficiency of removing the fluorine-containing compound having a hydrophilic group. Accordingly, the amount of the chain transfer agent used is more preferably 10,000 mass ppm or less, even more preferably 5,000 mass ppm or less, yet more preferably 1,000 mass ppm or less, particularly preferably 500 mass ppm or less, and most preferably 200 mass ppm or less, based on the total amount of the fluoromonomer fed.

The chain transfer agent may be added to the reaction vessel at once before initiation of the polymerization, may be added at once after initiation of the polymerization, may be added in multiple portions during the polymerization, or may be added continuously during the polymerization.

(Other additives)

Additives such as buffers, pH adjusters, stabilizing aids, and dispersion stabilizers can be used in the polymerization of the fluoromonomer. In the polymerization of the fluoromonomer, radical scavengers and decomposers may be added to regulate the polymerization rate and the molecular weight. Also, fluorine-free anionic surfactants, fluorine-free nonionic surfactants, fluorine-free cationic surfactants, and the like may be used in the polymerization of the fluoromonomer.

The stabilizing aid is preferably paraffin wax, fluorine-containing oil, a fluorine-containing solvent, silicone oil, or the like. One stabilizing aid may be used singly, or two or more may be used in combination. The stabilizing aid is more preferably paraffin wax. Paraffin wax may be in the form of a liquid, semi-solid, or solid at room temperature, and is preferably a saturated hydrocarbon having 12 or more carbon atoms. Usually, the melting point of paraffin wax is preferably 40 to 65°C, and more preferably 50 to 65°C.

The amount of the stabilizing aid used is preferably 0.1 to 12% by mass, and more preferably 0.1 to 8% by mass, based on the mass of the aqueous medium used. Desirably, the stabilizing aid is sufficiently hydrophobic so that the stabilizing aid is completely separated from the aqueous dispersion after polymerization, and does not serve as a contaminating component.

(Polymerization conditions)

The fluoromonomer can be polymerized at normal pressure and temperature. Usually, the polymerization temperature is 5 to 120°C, and the polymerization pressure is 0.05 to 10 MPaG. The polymerization temperature and the polymerization pressure are suitably determined according to the type of monomer, the molecular weight of the target perfluoropolymer compound X, the reaction rate, and the like.

(Aqueous dispersion obtained by polymerization)

Polymerization of the fluoromonomer yields an aqueous dispersion containing the perfluoropolymer compound X. The content of the perfluoropolymer compound X in the aqueous dispersion as polymerized is usually 8 to 50% by mass based on the aqueous dispersion.

The aqueous dispersion obtained by polymerizing the fluoromonomer usually contains, other than the perfluoropolymer compound X, a fluorine-containing surfactant used as a fluorine-containing compound having a hydrophilic group when polymerizing the fluoromonomer. Also, the aqueous dispersion obtained by polymerizing the fluoromonomer may contain, other than the perfluoropolymer compound X, a fluorine-containing compound having a hydrophilic group produced by polymerizing the fluoromonomer.

A typical fluorine-containing compound having a hydrophilic group in the aqueous dispersion obtained by polymerization is a fluorine-containing compound having a hydrophilic group and having a molecular weight of 1,000 g/mol or less. The above production method is capable of eventually producing a water dispersion composition in which the content of the fluorine-containing compound having a hydrophilic group and having a molecular weight of 1,000 g/mol or less is reduced.

The aqueous dispersion obtained by polymerization in one embodiment contains, as a fluorine-containing compound having a hydrophilic group, a fluorine-containing surfactant added during polymerization. The fluorine-containing surfactant added during polymerization is as described above as a fluorine-containing surfactant for use in the polymerization of the fluoromonomer.

The content of the fluorine-containing compound having a hydrophilic group in the aqueous dispersion obtained by polymerization may be 200 mass ppb or more, 300 mass ppb or more, and 400 mass ppb or more, and may be 10% by mass or less, 1% by mass or less, and 0.5% by mass or less, based on the aqueous dispersion.

The content of the fluorine-containing surfactant, used when polymerizing the fluoromonomer, in the aqueous dispersion obtained by polymerization may be 200 mass ppb or more, 300 mass ppb or more, and 400 mass ppb or more, and may be 10% by mass or less, 1% by mass or less, and 0.5% by mass or less, based on the aqueous dispersion.

The aqueous dispersion obtained by polymerization in one embodiment contains perfluoroether carboxylic acid as a fluorine-containing compound having a hydrophilic group. The perfluoroether carboxylic acid is preferably a compound (III) represented by the following general formula (III):

General formula (III): $Rf^1\text{-}O\text{-}(CF(CF_3)CF_2O)_{n3}CF(CF_3)COOM$

wherein $Rf^1$ is a perfluoroalkyl group having 1 to 5 carbon atoms, n3 is an integer of 0 to 3, M is H, a metal atom, $NR^7_4$, an optionally substituted imidazolium, optionally substituted pyridinium, or optionally substituted phosphonium, and $R^7$ is H or an organic group.

When the aqueous dispersion obtained by polymerization contains at least perfluoroether carboxylic acid as a fluorine-containing compound having a hydrophilic group, the content of perfluoroether carboxylic acid in the aqueous dispersion obtained by polymerization may be 200 mass ppb or more, 300 mass ppb or more, and 400 mass ppb or more, and may be 10% by mass or less, 1% by mass or less, and 0.5% by mass or less, based on the aqueous dispersion.

The aqueous dispersion obtained by polymerization in one embodiment contains a compound represented by the following general formula (H1) as a fluorine-containing compound having a hydrophilic group:

General formula (H1): $[X\text{-}Rf\text{-}A^-]_iM^{i+}$

wherein X is H, Cl, Br, F, or I; Rf is a linear or branched, partially fluorinated or fully fluorinated aliphatic group, or a linear or branched, partially fluorinated or fully fluorinated aliphatic group interrupted by at least one oxygen atom; $A^-$ is an acid group; $M^{i+}$ is a cation having a valence of i; and i represents an integer of 1 to 3.

The aqueous dispersion obtained by polymerization in one embodiment contains a compound represented by the following general formula (H2) as a fluorine-containing compound having a hydrophilic group:

General formula (H2): $[C_{n-1}F_{2n-1}COO^-]M^+$

wherein n is an integer of 4 to 14, and $M^+$ represents a cation.

The compound represented by the general formula (2) (perfluoroalkanoic acid) is known to be formed during polymerization when perfluoro(alkyl vinyl ether) or the like is used as a fluoromonomer (see International Publication No. WO 2019/161153).

The aqueous dispersion obtained by polymerization in one embodiment contains a compound represented by the following general formula (H3) as a fluorine-containing compound having a hydrophilic group:

General formula (H3): $[R^1\text{-}O\text{-}L\text{-}CO_2^-]M^+$

wherein $R^1$ is a linear or branched, partially fluorinated or fully fluorinated aliphatic group, or a linear or branched, partially fluorinated or fully fluorinated aliphatic group interrupted by at least one oxygen atom; L represents a linear or branched non-fluorinated, partially fluorinated, or fully fluorinated alkylene group; and $M^+$ represents a cation.

The aqueous dispersion obtained by polymerization in one embodiment contains a compound represented by the general formula (H4) as a fluorine-containing compound having a hydrophilic group:

General formula (H4): $H\text{-}Rf^{n0}\text{-}Y^0$

wherein $Rf^{n0}$ is a linear, branched, or cyclic alkylene group having 3 to 20 carbon atoms in which some or all of H are replaced by F; the alkylene group optionally containing one or more ether bonds in which some of H are replaced by Cl; and $Y^0$ is an anionic group.

Examples of the compound represented by the general formula (H4) include compounds represented by any of the following general formulae:

General formula: $[H\text{-} (CF_2)_mCO_2^-]M^+$

wherein m represents an integer of 3 to 19, and $M^+$ represents a cation; and

General formula: $[H\text{-} (CF_2)_{m2}\text{-}(CF(CF_3))_{m3}\text{-}CO_2^-]M^+$

wherein m2 represents an integer of 1 to 17, m3 represents an integer of 1 to 9, and $M^+$ represents a cation, provided that, m2 and m3 are selected so as to satisfy $3 \leq (m2 + 2 \times m3) \leq 19$, and each repeating unit occurs in any order in the formula.

(Removal of fluoromonomer or recovery of aqueous dispersion)

In the above production method, after the aqueous dispersion is prepared by polymerization and before adding a radical generator to the aqueous dispersion, at least one of the operations of (a) removing from the reactor the fluoromonomer remaining in the reactor, and (b) recovering the aqueous dispersion in the reactor to accommodate the aqueous dispersion in a container different from the reactor can be performed. In particular, a method that removes the fluoromonomer from the reactor is preferably used because the subsequent steps can be performed in the same reactor used in polymerization, and thus productivity of the water dispersion composition is increased.

After the aqueous dispersion is prepared, it is preferable to terminate the stirring of the contents of the reactor and

then remove the fluoromonomer or recover the aqueous dispersion because the subsequent operations become easy, or the polymerization of the fluoromonomer can be smoothly terminated.

The method for removing the fluoromonomer from the reactor is not limited. After the aqueous dispersion is prepared, the fluoromonomer may be removed from the reactor by terminating the stirring of the contents of the reactor if desired and discharging gas until the pressure inside the reactor reaches normal pressure, the fluoromonomer may be removed from the reactor by reducing the pressure inside the reactor to lower than 0.0 MPaG, or the fluoromonomer in the reactor may be replaced with an inert gas such as nitrogen gas by feeding an inert gas to the reactor. Also, the fluoromonomer may be removed from the reactor as a result of reacting the entirety of the fluoromonomer in the reactor to convert it to the perfluoropolymer compound X. As long as the removal from the reactor of the fluoromonomer remaining in the reactor can be performed to such an extent that the polymerization reaction of the fluoromonomer is sufficiently terminated, a small amount of the fluoromonomer may remain in the reactor. The removed fluoromonomer can be recovered by a known means. The recovered fluoromonomer may be reused to produce a fluoropolymer.

A preferable method for removing the fluoromonomer from the reactor may be a method involving, after the aqueous dispersion is prepared, terminating the stirring of the contents of the reactor if desired, reducing the pressure inside the reactor to less than 0.0 MPaG, and then feeding an inert gas to the reactor. Reducing the pressure inside the reactor and feeding an inert gas may be repeated multiple times.

When the fluoromonomer is polymerized at a temperature higher than normal temperature, the reactor may be cooled before removing the fluoromonomer from the reactor or after removing the fluoromonomer from the reactor. When the fluoromonomer is removed from the reactor by means of, for example, gas discharge or nitrogen purge, an unreacted fluoromonomer especially in a liquid form may remain in the reactor, and thus cooling the reactor can sufficiently suppress the progress of the reaction of the unreacted fluoromonomer.

The method for recovering the aqueous dispersion in the reactor and accommodating it in a container different from the reactor used in polymerization is not limited. For example, after the aqueous dispersion is prepared, the stirring of the contents of the reactor may be terminated if desired, the reactor may be opened, and the aqueous dispersion in the reactor may be poured into another container, or after the aqueous dispersion is prepared, the stirring of the contents of the reactor may be terminated if desired, the aqueous dispersion may be fed from the reactor to another container through a pipe that connects the reactor and another container.

To terminate the polymerization reaction of the fluoromonomer, a polymerization terminator (a radical scavenger) may be added.

The polymerization terminator may be a compound having no reinitiation ability after addition or chain transfer to a free radical in the polymerization system. Specifically, used is a compound that readily undergoes a chain transfer reaction with a primary radical or a propagating radical and then generates a stable radical that does not react with a monomer or a compound that readily undergoes an addition reaction with a primary radical or a propagating radical to generate a stable radical. The activity of what is commonly referred to as a chain transfer agent is characterized by the chain transfer constant and the reinitiation efficiency, and, among chain transfer agents, those having almost 0% reinitiation efficiency are referred to as polymerization terminators. The polymerization terminator is preferably at least one selected from the group consisting of aromatic hydroxy compounds, aromatic amines, N,N-diethylhydroxylamine, quinone compounds, terpenes, thiocyanates, and cupric chloride ($CuCl_2$). Examples of aromatic hydroxy compounds include unsubstituted phenols, polyhydric phenols, salicylic acid, m- or p-salicylic acid, gallic acid, and naphthol. Examples of unsubstituted phenols include o-, m-, or p-nitrophenol, o-, m-, or p-aminophenol, and p-nitrosophenol. Examples of polyhydric phenols include catechol, resorcin, hydroquinone, pyrogallol, phloroglucin, and naphthresorcinol. Examples of aromatic amines include o-, m-, or p-phenylenediamine and benzidine. Examples of quinone compounds include hydroquinone, o-, m- or p-benzoquinone, 1,4-naphthoquinone, and alizarin. Examples of thiocyanates include ammonium thiocyanate ($NH_4SCN$), potassium thiocyanate (KSCN), and sodium thiocyanate (NaSCN). In particular, the polymerization terminator is preferably a quinone compound, and more preferably hydroquinone.

(Radical generator)

In the above production method, after performing at least one of the operations (a) and (b) and before heat-treating the aqueous dispersion, a radical generator is added to the aqueous dispersion in an amount corresponding to 5 mol or more per mole of the fluorine-containing surfactant used in the polymerization. By adding a relatively large amount of a radical generator, the content of the fluorine-containing compound having a hydrophilic group can be sufficiently reduced.

The aqueous dispersion to which the radical generator is added may be the aqueous dispersion remaining in the reactor, or the aqueous dispersion recovered from the reactor and accommodated in another container.

The radical generator is not limited as long as it is a compound that can generate radicals by being decomposed at a heat treatment temperature. The radical generator is preferably a water-soluble radical generator because radicals can be easily diffused in the aqueous dispersion.

Examples of the radical generator include organic peroxides, inorganic peroxides, organic azo compounds, and combinations of oxidizing agents and reducing agents, and preferable is at least one selected from the group consisting of inorganic peroxides, organic peroxides, and combinations of oxidizing agents and reducing agents.

The inorganic peroxide is preferably a water-soluble inorganic peroxide. Examples of the inorganic peroxide include hydrogen peroxide, perchlorates, perborates, perphosphates, percarbonates, and persulfates, and a persulfate is preferable. The persulfate is preferably at least one selected from the group consisting of ammonium persulfate, sodium persulfate, and potassium persulfate, and more preferably ammonium persulfate.

The organic peroxide is preferably a water-soluble organic peroxide. Examples of the organic peroxide include peroxydicarbonates such as disuccinic acid peroxide and diglutaric acid peroxide.

The radical generator may be a combination of an oxidizing agent and a reducing agent. The use of a combination of an oxidizing agent and a reducing agent enables radicals to be generated from the radical generator through a redox reaction between the oxidizing agent and the reducing agent, and thus the temperature during heat treatment can be lowered.

Examples of the oxidizing agent include persulfates, organic peroxides, potassium permanganate, manganese triacetate, and ammonium cerium nitrate. Examples of the reducing agent include sulfites, bisulfites, bromates, diimines, and oxalic acid. Examples of persulfate include ammonium persulfate and potassium persulfate. Examples of sulfites include sodium sulfite and ammonium sulfite. In order to increase the decomposition rate of the oxidizing agent, a copper salt or an iron salt is also preferably added. An example of the copper salt is copper(II) sulfate, and an example of the iron salt is iron(II) sulfate.

Examples of the combination of an oxidizing agent and a reducing agent include potassium permanganate/oxalic acid, ammonium persulfate/bisulfite/iron sulfate, manganese triacetate/oxalic acid, cerium ammonium nitrate/oxalic acid, and bromate/bisulfite, and potassium permanganate/oxalic acid is preferable. When using a combination of an oxidizing agent and a reducing agent, one of an oxidizing agent and a reducing agent may be added to the aqueous dispersion in advance, and then the other may be added continuously or intermittently.

Because the efficiency of removing the fluorine-containing compound having a hydrophilic group can be more increased, the amount of the radical generator added is preferably 5 mol or more and more preferably 10 mol or more, and is preferably 1,000 mol or less, more preferably 500 mol or less, and even more preferably 100 mol or less, per mole of the fluorine-containing surfactant used in polymerization.

The method for adding the radical generator is not limited. The radical generator may be added as-is to the aqueous dispersion, or a solution containing the radical generator may be prepared and added to the aqueous dispersion. The radical generator may be added while stirring the aqueous dispersion, or the aqueous dispersion may be stirred after adding the radical generator.

The temperature of the aqueous dispersion to which the radical generator is added is not limited, and it may be the temperature of the aqueous dispersion after the fluoromonomer is polymerized, may be the temperature reached by cooling the aqueous dispersion after the fluoromonomer is polymerized, or may be the temperature of the heat treatment. That is to say, after the radical generator is added to the aqueous dispersion, the aqueous dispersion may be heated for heat treatment, or after the aqueous dispersion is heated to the temperature for heat treatment, the radical generator may be added to the aqueous dispersion.

(Heat treatment)

In the above production method, the aqueous dispersion to which the radical generator is added (the aqueous dispersion containing the radical generator) is heat-treated. By heat-treating the aqueous dispersion containing a relatively large amount of radical generator, the content of the fluorine-containing compound having a hydrophilic group in the aqueous dispersion can be surprisingly reduced.

The content of the perfluoropolymer compound X in the aqueous dispersion may be regulated before heat treatment. The content of the perfluoropolymer compound X can be regulated by a known method such as concentration or dilution.

The content of the perfluoropolymer compound X in the aqueous dispersion to be subjected to heat treatment is preferably 1% by mass or more, more preferably 5% by mass or more, and even more preferably 10% by mass or more based on the mass of the aqueous dispersion because the aqueous dispersion containing the perfluoropolymer compound X can be produced at high productivity without impairing the efficiency of removing the fluorine-containing compound having a hydrophilic group. The upper limit of the content of the perfluoropolymer compound X is preferably 60% by mass or less, more preferably 55% by mass or less, and even more preferably 50% by mass or less.

The content of the fluorine-containing surfactant added during polymerization, in the aqueous dispersion to be subjected to heat treatment, is preferably 500 mass ppm or more and more preferably 1,000 mass ppm or more, and is preferably 10% by mass or less, more preferably 5% by mass or less, and even more preferably 1% by mass or less, based on the mass of the perfluoropolymer compound X in the aqueous dispersion.

The content of the fluorine-containing compound having a hydrophilic group produced by the polymerization of the fluoromonomer, in the aqueous dispersion to be subjected to heat treatment, is preferably 500 mass ppb or more and more preferably 1,000 mass ppb or more, and is preferably 1.0% by mass or less, more preferably 0.1% by mass or less, and even more preferably 0.01% by mass or less, based on the mass of the perfluoropolymer compound X in the aqueous dispersion.

The content of the fluorine-containing compound having a hydrophilic group in the aqueous dispersion to be subjected to heat treatment (the total of the content of the fluorine-containing surfactant added during polymerization and the content of the fluorine-containing compound having a hydrophilic group produced by the polymerization of the fluoromonomer) is preferably 500 mass ppm or more and more preferably 1,000 mass ppm or more, and is preferably 10% by mass or less, more preferably 5% by mass or less, and even more preferably 1% by mass or less, based on the perfluoropolymer compound X in the aqueous dispersion.

The temperature of heat treatment is preferably 35°C or higher, more preferably 40°C or higher, even more preferably 45°C or higher, and particularly preferably 50°C or higher, and is preferably 120°C or lower, more preferably 110°C or lower, even more preferably 100°C or lower, and particularly preferably 90°C or lower, because the efficiency of removing the fluorine-containing compound having a hydrophilic group can be more increased. When heat-treating the aqueous dispersion to which a radical generator is added, the temperature of the heat treatment is preferably higher than the temperature at which the radical generator decomposes and produces a radical (the decomposition temperature).

In the heat treatment of the aqueous dispersion, it is not always necessary to heat the aqueous dispersion as long as the aqueous dispersion can be maintained at a desired temperature or higher. For example, when the temperature at which the fluoromonomer is polymerized is sufficiently high and the temperature of the resulting aqueous dispersion is also sufficiently high, the heat treatment can be initiated before the resulting aqueous dispersion is cooled. However, it is preferable to cool the aqueous dispersion before and after removing the fluoromonomer from the reactor or recovering the aqueous dispersion present in the reactor, heat the aqueous dispersion to the above temperature range, and maintain that temperature for a certain period of time, thus facilitating the control of the heat treatment temperature. The temperature of the aqueous dispersion to be subjected to the heat treatment may be, for example, 30°C or lower.

The means of heating when performing heat treatment while heating the aqueous dispersion is not limited. For example, a container accommodating the aqueous dispersion may be placed in a constant-temperature vessel and heated, or the aqueous dispersion may be accommodated in a container equipped with a heater, and heated by the heater.

The pressure during heat treatment is not limited, and may be normal pressure. For example, when the temperature during heat treatment is relatively high, and boiling of the aqueous dispersion needs to be suppressed, the pressure during heat treatment may exceed normal pressure.

The heat treatment time is preferably 15 minutes or more, more preferably 30 minutes or more, and even more preferably 60 minutes or more, and is preferably 1,200 minutes or less, more preferably 900 minutes or less, and even more preferably 600 minutes or less, because the efficiency of removing the fluorine-containing compound having a hydrophilic group can be more increased.

Heat treatment may be performed while stirring the aqueous dispersion.

(Film and coated article)

The electrodeposition coating material composition of the present disclosure can be used to form a film. A film formed from the electrodeposition coating material composition of the present disclosure has no cracks, has low surface roughness, and has a low relative dielectric constant.

A film formed from the electrodeposition coating material composition can be formed on, for example, a substrate. In a coated article comprising a substrate and a film formed from the electrodeposition coating material composition of the present disclosure, the film has no cracks, has low surface roughness, and has a low relative dielectric constant, and, moreover, the substrate and the film are firmly adhered.

Examples of the material forming the substrate include simple metals such as iron, aluminum, and copper, and metals such as alloys thereof. Examples of the alloys include stainless steel. The substrate may contain another material together with the metal material.

The substrate can be composed of a material such as copper, copper alloy, aluminum, aluminum alloy, iron, silver, or nickel, and is preferably composed of copper, copper alloy, aluminum, or aluminum alloy.

The thickness of the film is preferably 2 to 100 μm and more preferably 5 μm or more, and is more preferably 70 μm or less, and even more preferably 30 μm or less.

The relative dielectric constant of the film is preferably 2.0 to 2.4, and more preferably 2.3 or less.

Examples of the coated article include cooking utensils such as frying pans, pressure cookers, pots, grill pots, rice cookers, ovens, hot plates, bread baking pans, kitchen knives, and gas tables; kitchen supplies such as electric kettles, ice trays, metal dies, and range hoods; food industry components such as kneading rolls, stretching rolls, conveyors, and hoppers; industrial supplies such as office automation (OA) rolls, OA belts, OA separation claws, paper making rolls, and

calender rolls for film production; metal dies and stamping dies for, for example, styrene foam molding; metal mold releases such as mold release boards for, for example, plywood and decorative plate production; industrial containers (especially for semiconductor industry); tools such as saws and files; household utensils such as irons, scissors, and cooking knives; metal foil; coated electric wires; printed circuit boards; sliding bearings for, for example, food processing machines, packaging machines, and textile machines; sliding parts for cameras and watches; automobile parts such as pipes, valves, and bearings; snow shovels; plows; and chutes.

The coated article, in particular, is preferably a coated electric wire or a printed circuit board.

(Coated electric wire)

The electrodeposition coating material composition of the present disclosure can be used to form a film that is a coating of a coated electric wire. The coated electric wire comprises, for example, an electric wire substrate and a film formed around the rectangular electric wire substrate. In the coated electric wire comprising a film formed from the electrodeposition coating material composition of the present disclosure, the film has no cracks, has low surface roughness, and has a low relative dielectric constant, and, moreover, the substrate and the film are firmly adhered.

The coated electric wire in one embodiment comprises a rectangular electric wire substrate and a film that is formed around the rectangular electric wire substrate and that is formed from the electrodeposition coating material composition.

The shape of the rectangular electric wire substrate is not limited as long as the cross section thereof has the shape of a substantially rectangular wire. The corners of the cross section of the rectangular electric wire substrate may be right angle, or the corners of the cross section of the rectangular electric wire substrate may be rounded. The rectangular electric wire substrate may be a solid wire, a grouped wire, a stranded wire, or the like as long as the cross section of the whole is substantially rectangular, and is preferably a solid wire.

The rectangular electric wire substrate is not limited as long as it is composed of a conductive material, and the rectangular electric wire substrate can be composed of a material such as copper, copper alloy, aluminum, aluminum alloy, iron, silver, or nickel, and is preferably composed of copper, copper alloy, aluminum, or aluminum alloy. A rectangular electric wire substrate provided with plating such as silver plating or nickel plating can also be used. Copper may be oxygen-free copper, low-oxygen copper, copper alloy, or the like.

The width of the cross section of the rectangular electric wire substrate may be 1 to 75 mm, and the thickness of the cross section of the rectangular electric wire substrate may be 0.1 to 30 mm. The outer circumference of the rectangular electric wire substrate may be 6.5 mm or more and 200 mm or less. The ratio of width to thickness may be greater than 1 and 30 or less.

The surface roughness Sz of the rectangular electric wire substrate is preferably 0.2 to 12 μm, more preferably 1 μm or more, and even more preferably 5 μm or more, and is more preferably 10 μm or less, because the rectangular electric wire substrate and the film adhere more firmly.

The surface roughness of the rectangular electric wire substrate can be regulated by surface-treating the rectangular electric wire substrate using a surface treatment method such as etching treatment, blasting treatment, or laser treatment. The surface of the rectangular electric wire substrate may be provided with irregularities by surface treatment. The distance between the irregularities from a protrusion to a protrusion is preferably as small as possible, e.g., 5 μm or less. Regarding the size of irregularities, for example, the area of one depression when a protrusion on an untreated surface is cut is 1 $\mu m^2$ or less. The shape of irregularities may be a single crater-type irregularity shape, or may be branched like an ant colony.

A film on the substrate such as a rectangular electric wire substrate can be formed by electrodepositioncoating the substrate with the electrodeposition coating material composition. Electrodeposition coating can be performed by, for example, immersing the substrate in the electrodeposition coating material composition and applying electricity using the substrate as an anode. Conditions for electrodeposition coating are suitably selected according to the type of substrate and the like. For example, the temperature of the electrodeposition coating material composition can be 10 to 40°C, the voltage can be 50 to 500 V, and the duration of applying electricity can be 1 to 10 minutes.

After electrodeposition coating, the film precipitated on the substrate may be washed with water. After electrodeposition coating, the film precipitated on the substrate is subjected to baking drying. Drying may be performed once or multiple times. For example, after preliminary drying at low temperature, baking drying may be performed at high temperature.

The electrodeposition coating material composition of the present disclosure contains a neutralized product of a methacrylate resin. It is thus preferable to select drying conditions wherein the film can be baked onto the substrate and, also, only a part of the neutralized product of a methacrylate resin in the electrodeposition coating material composition remains in the film. By selecting such conditions, a film can be obtained that has no cracks, has low surface roughness, firmly adheres to the substrate, and also has a low relative dielectric constant.

The drying temperature is preferably 300°C or higher, and more preferably 350°C or higher. The upper limit of the

drying temperature may be 400°C or lower from the viewpoint of suppressing substrate oxidation and film deterioration. The drying time is preferably 5 minutes or more, and more preferably 10 minutes or more. The upper limit of the drying time may be 60 minutes or less from the viewpoint of suppressing substrate oxidation and film deterioration.

Performing the drying in the absence of oxygen enables substrate oxidation to be suppressed. Drying the film deposited on the substrate in the presence of oxygen may damage the substrate. Drying can be performed in, for example, an inert gas that contains no more than 1% by weight of oxygen gas. For example, the inert gas may be nitrogen gas.

(Coating layer of coated electric wire)

The coated electric wire of the present disclosure can further comprise a coating layer formed around the film. The coating layer may be a coating formed from a coating material composition or an extrudate formed from an extrusion forming composition. The coating layer may be a single layer, or may be two or more layers.

While the coating material composition may be a liquid coating material composition or a powder coating material composition, a powder coating material composition is preferable because a relatively thick coating layer can be easily formed.

The powder coating material composition may be a powder coating material composition containing a powder of a fluorine-containing polymer compound Y. In the present disclosure, the term "powder coating material composition" is used even when the powder coating material composition is composed solely of a powder of the fluorine-containing polymer compound Y, or that is to say, even when the powder coating material composition does not contain multiple components.

The layer formed from the coating material composition can be formed by applying the coating material composition around the film.

The method for forming the layer by applying the powder coating material composition is not limited, and examples include methods such as electrostatic coating and fluidized bed coating.

The layer may be formed by applying the powder coating material composition and then firing the resulting coating film. While firing can be performed by a conventionally known method, firing is preferably performed at a temperature equal to or higher than the melting point or the curing temperature of the fluorine-containing polymer compound Y for 5 to 60 minutes. Firing may be performed each time the coating material composition is applied, or may be performed after the coating material composition is applied multiple times to form a plurality of layers (coating films).

The extrusion forming composition may be a composition containing a fluorine-containing polymer compound Z. In the present disclosure, the term "extrusion forming composition" is used even when the extrusion forming composition is composed solely of the fluorine-containing polymer compound Z, or that is to say, even when the extrusion forming composition does not contain multiple components.

The extrusion forming method is used as a method for forming a layer by extruding the fluorine-containing polymer compound Z (an extrusion forming composition). For example, using an extruder, a layer can be formed by thermally melting the fluorine-containing polymer compound and extruding the molten fluorine-containing polymer compound onto the film.

The type of extruder is not limited, and the shape of the screw that the extruder has is also not limited. For example, an extruder barrel of 30 mmφ, a L/D of 24, a fullflight screw, a compression ratio of 2.8, concerning the temperature condition of extrusion, the temperatures of C1 below the hopper, then C2, C3, and C4, and the cylinder are regulated, and the temperatures of the respective parts of head, die, and dice are regulated. The die shape is crosshead, and an electric wire is inserted perpendicular to extrusion to be coated with the fluorine-containing polymer compound. The die/chip is used that is adjusted according to the desired shape of a rectangular electric wire substrate and the coating thickness. Different dies such as a tubing die and a pressure die can also be used for different purposes. Cooling of the resin after extrusion coating can be controlled by taking into consideration air cooling, water cooling, heat retention/cooling, and the desired physical properties of the fluorine-containing polymer compound and physical properties of the electric wire.

The coated electric wire may be heat-treated. The heat treatment may be performed before cooling or may be performed after cooling as long as it is performed after the coating layer is formed. The heat treatment temperature is usually equal to or higher than the glass transition point of the fluorine-containing polymer compound, and is preferably 10 to 15°C lower than the melting point of the fluorine-containing polymer compound.

The coating layer in one embodiment is an extrudate formed from the extrusion forming composition by an extrusion forming method. The extrudate enables a thicker layer to be easily formed than a coating film formed from the coating material composition. For example, the thickness of the extrudate (the thickness of a layer formed from the extrusion forming composition) may be 90 μm or more, and the thickness of the coating film (the thickness of a layer formed from the coating material composition) may be less than 90 μm.

The thickness of the coating film formed from the coating material composition containing the fluorine-containing polymer compound Y is preferably 5 to 100 μm, more preferably 50 μm or more, and even more preferably 75 μm or more,

and is more preferably less than 90 μm.

The thickness of the layer formed by extrusion forming of the extrusion forming composition containing the fluorine-containing polymer compound Z is preferably 25 to 400 μm, more preferably 50 μm or more, even more preferably 75 μm or more, and yet more preferably 90 μm or more, and is more preferably 290 μm or less and even more preferably 240 μm or less.

The relative dielectric constant of the coating layer is preferably 2.0 to 2.4, and more preferably 2.3 or less.

Examples of the fluorine-containing polymer compound Y contained in the powder coating material composition include polytetrafluoroethylene, a TFE/FAVE copolymer, a TFE/HFP copolymer, a TFE/FAVE/HFP copolymer, a TFE/ethylene copolymer [ETFE], a TFE/ethylene/HFP copolymer, an ethylene/chlorotrifluoroethylene (CTFE) copolymer [ECTFE], polychlorotrifluoroethylene [PCTFE], a CTFE/TFE copolymer, polyvinylidene fluoride [PVdF], a TFE/vinylidene fluoride (VdF) copolymer [VT], a polyvinyl fluoride [PVF], a TFE/VdF/CTFE copolymer [VTC], and a TFE/HFP/VdF copolymer.

The fluorine-containing polymer compound Y contained in the powder coating material composition, in particular, is preferably a perfluoropolymer compound. The perfluoropolymer compound may be a polymer described as the perfluoropolymer compound X. The fluorine-containing polymer compound Y is preferably a melt-fabricable perfluoropolymer compound, and more preferably at least one selected from the group consisting of a TFE/FAVE copolymer, a TFE/HFP copolymer, and a TFE/FAVE/HFP copolymer.

Examples of the fluorine-containing polymer compound Z contained in the extrusion forming composition include polytetrafluoroethylene, a TFE/FAVE copolymer, a TFE/HFP copolymer, a TFE/FAVE/HFP copolymer, a TFE/ethylene copolymer [ETFE], a TFE/ethylene/HFP copolymer, an ethylene/chlorotrifluoroethylene (CTFE) copolymer [ECTFE], polychlorotrifluoroethylene [PCTFE], a CTFE/TFE copolymer, polyvinylidene fluoride [PVdF], a TFE/vinylidene fluoride (VdF) copolymer [VT], a polyvinyl fluoride [PVF], a TFE/VdF/CTFE copolymer [VTC], and a TFE/HFP/VdF copolymer.

The fluorine-containing polymer compound Z contained in the extrusion forming composition, in particular, is preferably a perfluoropolymer compound. The perfluoropolymer compound may be a polymer described as the perfluoropolymer compound X. The fluorine-containing polymer compound Z is preferably a melt-fabricable perfluoropolymer compound, and more preferably at least one selected from the group consisting of a TFE/FAVE copolymer, a TFE/HFP copolymer, and a TFE/FAVE/HFP copolymer.

The coating material composition, the extrusion forming composition, and the coating layer may contain a further component as necessary. Examples of the further component include additives such as crosslinking agents, antistatic agents, heat stabilizers, foaming agents, foam nucleating agents, antioxidants, surfactants, photoinitiators, anti-wear agents, surface modifiers, various organic and inorganic pigments, copper inhibitors, bubble preventing agents adhesion imparting agents, lubricants, processing aids, colorants, phosphorous stabilizers, lubricants, mold release agents, sliding materials, ultraviolet absorbers, dyes and pigments, reinforcing materials, anti-dripping agents, fillers, curing agents, ultraviolet curing agents, and flame retardants.

The coated electric wire of the present disclosure can be suitably used for, for example, a LAN cable, a USB cables, a Lightning cable, an HDMI cable, a QSFP cable, an aerospace electric wire, an underground power cable, a submarine power cable, a high voltage cables, a superconducting cable, a wrapping electric wire, an automobile electric wire, a wire harness/electrical component, an electric wire for robots/FA, an electric wire for OA equipment, an electrical wire for information equipment (such as an optical fiber cable, a LAN cable, an HDMI cable, a Lightning cable, and an audio cable), an internal wiring for communication base stations, a large-current internal wiring (such as an inverter, a power conditioner, and a rechargeable battery system), an internal wiring of electronic equipment, a small electronic equipment/mobile device wiring, a wiring for moving parts, an internal wiring of electric equipment, an internal wiring of measuring equipment, a power cable (for construction, wind/solar power generation, etc.), a control/instrumentation wiring cable, and a motor cable.

The coated electric wire of the present disclosure can be wound and used as a coil. The coated electric wire and the coil of the present disclosure can be suitably used in electrical equipment or electronic equipment, such as motors, generators, and inductors. Also, the coated electric wire and the coil of the present disclosure can be suitably used in onboard electric equipment or onboard electronic equipment, such as onboard motors, onboard generators, and onboard inductors.

The coated electric wire may be a continuous electric wire, may be a short electric wire, or may be a coated electric wire having a bent part as shown in Figure 1.

The coated electric wire having a bent part according to one embodiment comprises a rectangular electric wire substrate having one or more bent parts bent in the edgewise direction and a film formed around the rectangular electric wire substrate. The coated electric wire having a bent part can be suitably used as, for example, a segment coil to be inserted into a slot formed in a stator core or a rotor core. For example, as a segment coil, a coil can be formed by inserting coated electric wires having a bent part into a slot and joining the ends of each coated electric wire.

Figure 1 shows a front view and a top view of a coated electric wire having a bent part according to one embodiment. Figure 2 shows a cross-sectional view of a coated electric wire having a bent part according to one

embodiment. A coated electric wire 100 having a bent part shown in Figure 1 is a resin-coated conductor (a segment coil) for forming a coil by being inserted into each slot of the core of a rotating electric machine. The resin-coated conductor 100 is formed by bending a resin-coated conductor having a predetermined length into a U-shape in the flatwise direction. As shown in Figure 2, the resin-coated conductor 100 comprises a rectangular electric wire substrate 21 and a film 22 formed around the rectangular electric wire substrate 21.

As shown in Figure 1, the resin-coated conductor 100 is substantially U-shaped and is composed of a curved part 11 and slot insertion parts 12 extending from the respective ends of the curved part 11. At the portions connecting the curved part 11 and the slot insertion parts 12, shoulder parts 13a and 13b are formed by bending the rectangular electric wire substrate in the edgewise direction. Also, the curved part 11 has a protruding part 14 formed by bending the rectangular electric wire substrate in the edgewise direction and a cranked part 15 formed by bending the rectangular electric wire substrate in the flatwise direction.

While embodiments have been described above, it will be understood that various changes in form and detail can be made without departing from the gist and scope of the claims.

<1> According to the first aspect of the present disclosure, provided is

an electrodeposition coating material composition comprising a perfluoropolymer compound X and a neutralized product of a methacrylate resin, wherein
the perfluoropolymer compound X has a relative dielectric constant of 2.0 to 2.2,
the methacrylate resin has an acid value of 10 mgKOH/g or more, and
the electrodeposition coating material composition has a solid concentration of 10 to 70% by mass.

<2> According to the second aspect of the present disclosure, provided is

an electrodeposition coating material composition comprising a perfluoropolymer compound X and a neutralized product of a methacrylate resin, wherein
the perfluoropolymer compound X is a tetrafluoroethylene/fluoroalkyl vinyl ether copolymer,
the methacrylate resin has an acid value of 10 mgKOH/g or more, and
the electrodeposition coating material composition has a solid concentration of 10 to 70% by mass.

<3> According to the third aspect of the present disclosure, provided is
the electrodeposition coating material composition according to the first or second aspect, wherein the content of the fluorine-containing compound having a hydrophilic group is 50 mass ppb or less based on the perfluoropolymer compound X.

<4> According to the fourth aspect of the present disclosure, provided is
the electrodeposition coating material composition according to any one of the first to third aspects, further comprising water.

<5> According to the fifth aspect of the present disclosure, provided is
the electrodeposition coating material composition according to any one of the first to fourth aspects, which is obtained by a production method comprising phase inversion emulsification by adding a water dispersion composition containing the perfluoropolymer compound X and water to a solution containing the neutralized product of the methacrylate resin and an organic solvent.

<6> According to the sixth aspect of the present disclosure, provided is
the electrodeposition coating material composition according to any one of the first to fifth aspects, wherein the methacrylate resin has carboxyl group, and the neutralized product of the methacrylate resin is a neutralized product obtained by neutralizing the methacrylate resin having carboxyl group with an amine compound.

<7> According to the seventh aspect of the present disclosure, provided is
the electrodeposition coating material composition according to any one of the first to sixth aspects, wherein the neutralized product of the methacrylate resin has a degree of neutralization of 50% or more.

<8> According to the eighth aspect of the present disclosure, provided is
the electrodeposition coating material composition according to any one of the first to seventh aspects, wherein the perfluoropolymer compound X has a functional group, and the number of functional groups in the perfluoropolymer compound X is 5 to 2,000 per $10^6$ carbon atoms.

<9> According to the ninth aspect of the present disclosure, provided is
the electrodeposition coating material composition according to any one of the first to eighth aspects, having an alkali metal content of less than 1 mass ppm.

<10> According to the tenth aspect of the present disclosure, provided is

the electrodeposition coating material composition according to any one of the first to ninth aspects, wherein a mass ratio of the perfluoropolymer compound X to the neutralized product of the methacrylate resin is 10/90 to 90/10.
<11> According to the eleventh aspect of the present disclosure, provided is
a film formed from the electrodeposition coating material composition according to any one of the first to tenth aspects.
<12> According to the twelfth aspect of the present disclosure, provided is

a coated article comprising a substrate and a film with which the substrate is coated, wherein
the film is formed from the electrodeposition coating material composition according to any one of the first to tenth aspects.

<13> According to the thirteenth aspect of the present disclosure, provided is
the coated article according to the twelfth aspect, wherein a material that forms the substrate is at least one selected from the group consisting of copper, copper alloy, aluminum, and aluminum alloy.
<14> According to the fourteenth aspect of the present disclosure, provided is

a coated electric wire comprising a rectangular electric wire substrate and a film formed around the rectangular electric wire substrate, wherein
the film is formed from the electrodeposition coating material composition according to any one of the first to tenth aspects.

<15> According to the fifteenth aspect of the present disclosure, provided is
the coated electric wire according to the fourteenth aspect, wherein a material that forms the rectangular electric wire substrate is at least one selected from the group consisting of copper, copper alloy, aluminum, and aluminum alloy.
<16> According to the sixteenth aspect of the present disclosure, provided is
the coated electric wire according to the fourteenth or fifteenth aspect, having a bent part.
<17> According to the seventeenth aspect of the present disclosure, provided is
the coated electric wire according to the fourteenth or fifteenth aspect, which is a continuous electric wire.
<18> According to the eighteenth aspect of the present disclosure, provided is

the coated electric wire according to any one of the fourteenth to seventeenth aspects, further comprising a coating layer formed around the film, wherein
the coating layer is a layer formed from a powder coating material composition comprising a fluorine-containing polymer compound Y.

<19> According to the nineteenth aspect of the present disclosure, provided is

the coated electric wire according to any one of the fourteenth to seventeenth aspects, further comprising a coating layer formed around the film, wherein
the coating layer is a layer formed by extrusion forming of a fluorine-containing polymer compound Z.

<20> According to the twentieth aspect of the present disclosure, provided is

the coated electric wire according to the eighteenth aspect, wherein the fluorine-containing polymer compound Y is a perfluoropolymer compound,
the fluorine-containing polymer compound Y has a relative dielectric constant of 2.0 to 2.2, and
the fluorine-containing polymer compound Y has a melting point of 250 to 320°C.

<21> According to the twenty-first aspect of the present disclosure, provided is
the coated electric wire according to the eighteenth aspect, wherein the fluorine-containing polymer compound Y has a melt flow rate of 0.1 to 100 g/10 min.
<22> According to the twenty-second aspect of the present disclosure, provided is
the coated electric wire according to the eighteenth aspect, wherein the fluorine-containing polymer compound Y has a functional group, and the number of functional groups is 5 to 1,000 per $10^6$ carbon atoms.
<23> According to the twenty-third aspect of the present disclosure, provided is
the coated electric wire according to the eighteenth aspect, wherein the fluorine-containing polymer compound Y has a functional group, and the number of functional groups is 0 to 4 per $10^6$ carbon atoms.
<24> According to the twenty-fourth aspect of the present disclosure, provided is

a printed circuit board comprising a substrate and a film with which the substrate is coated, wherein the film is formed from the electrodeposition coating material composition according to any one of the first to tenth aspects.

<25> According to the twenty-fifth aspect of the present disclosure, provided is the printed circuit board according to the twenty-fourth aspect, wherein a material that forms the substrate is at least one selected from the group consisting of copper, copper alloy, aluminum, and aluminum alloy.

EXAMPLES

Next, embodiments of the present disclosure will now be described by way of Examples, but the present disclosure is not limited only to the Examples.
Various properties shown in the Examples were measured by the following methods.

(Number of functional groups in perfluoropolymer compound X, fluorine-containing polymer compound Y, and fluorine-containing polymer compound Z)

A polymer compound was melted at 330 to 340°C for 30 minutes and compression-molded to prepare a film having a thickness of 0.20 to 0.25 mm. This film was 40 times scanned and analyzed by a Fourier transform infrared spectrometer FT-IR (trade name: Model 1760X, manufactured by PerkinElmer, Inc.) to obtain an infrared absorption spectrum, and a difference spectrum against a base spectrum that is completely fluorinated and has no functional groups was obtained. From an absorption peak of a specific functional group observed on this difference spectrum, the number N of functional groups per $10^6$ carbon atoms in the polymer compound was calculated according to the following formula (A).

$$N = I \times K/t \quad (A)$$

I: absorbance
K: correction factor
t: thickness of film (mm)

For reference, the absorption frequencies, the molar absorption coefficients, and the correction factors of the functional groups in the present disclosure are shown in the table. Then, the molar absorption coefficients are those determined from FT-IR measurement data of low molecular model compounds.

[Table 2]

**Table 2**

| Functional Group | Absorption Frequency ($cm^{-1}$) | Molar Extinction Coefficient (l/cm/mol) | Correction Factor | Model Compound |
|---|---|---|---|---|
| -COF | 1883 | 600 | 388 | $C_7F_{15}COF$ |
| -COOH free | 1815 | 530 | 439 | $H(CF_2)_6COOH$ |
| -COOH bonded | 1779 | 530 | 439 | $H(CF_2)_6COOH$ |
| $-COOCH_3$ | 1795 | 680 | 342 | $C_7F_{15}COOCH_3$ |
| $-CONH_2$ | 3436 | 506 | 460 | $C_7H_{15}CONH_2$ |
| $-CH_2OH_2$, -OH | 3648 | 104 | 2236 | $C_7H_{15}CH_2OH$ |
| $-CF_2H$ | 3020 | 8.8 | 26485 | $H(CF_2CF_2)_3CH_2OH$ |
| $-CF=CF_2$ | 1795 | 635 | 366 | $CF_2=CF_2$ |

(Resin acid value)

A depolymerizable methacrylate resin was dissolved in a mixed solvent of xylene and isopropyl alcohol and then

titrated with a 0.1 mol/L potassium hydroxide/ethanol solution by potentiometric titration to determine the inflection point on the titration curve as an end point, and the acid value was calculated from the titer of the potassium hydroxide solution to the end point.

(Degree of neutralization of depolymerizable methacrylate resin)

Tetrahydrofuran was added to the depolymerizable methacrylate resin, and then the mixture was titrated to the equivalence point with a 0.1 mol/L hydrochloric acid solution by potentiometric titration to determine the inflection point on the titration curve as an amine value. This amine value was divided by the acid value to calculate the degree of neutralization.

(Relative dielectric constant of polymer compound)

The relative dielectric constant was measured at a temperature of 23°C ± 2°C at a relative humidity of 50% at a frequency of 1 KHz in accordance with JIS-C-2138.

(Melt flow rate (MFR))

The mass of a copolymer flowing out from a nozzle having an inner diameter of 2.1 mm and a length of 8 mm per 10 min (g/10 min) at 372°C under a load of 5 kg using a melt indexer (manufactured by YASUDA SEIKI SEISAKUSHO, LTD.) was obtained in accordance with to ASTM D 1238.

(Alkali metal content in electrodeposition coating material composition)

The alkali metal content in the electrodeposition coating material composition was measured by inductively coupled plasma mass spectrometry.

(Film thickness)

The film thickness was measured with a coating thickness tester LZ-373 manufactured by Kett Electric Laboratory Co. Ltd. The thickness of a film that had visually observable cracks was not measured, and denoted as "cracked".

(Surface roughness of film)

The surface roughness Ra of a film was measured with a surface roughness tester Surtronic DUO II manufactured by Taylor Hobson. The thickness of a film that had visually observable cracks was not measured, and denoted as "cracked".

(Adhesion strength between film and substrate)

The adhesion strength between a film and a substrate was measured with an AGS-J Autograph (50N) (manufactured by Shimadzu Corporation). Two substantially parallel 50 mm cuts were made in the long axis direction, both ends thereof were cut perpendicularly to the film in the short axis direction, and the ends were peeled 10 cm and sandwiched between the upper chucks. A conductor was fixed to the bottom part such that the long surface direction was horizontal. Using a jig that moves in the transverse direction according to the distance of its movement in the longitudinal direction when the apparatus was moved in the tensile direction, the angle was adjusted such that the peeled film was always perpendicular to the conductor in the long surface direction. The tensile stress when the sample was pulled at 100 mm/min and peeled by 30 mm was measured, and the maximum point stress thereof was regarded as adhesion strength. The adhesion strength of a film that had visually observable cracks was not measured, and denoted as "cracked".

(Relative dielectric constant of film)

Capacitance was obtained using an LCR HiTester 3522-50 manufactured by Hioki E.E. Corporation, and the relative dielectric constant was calculated from the following formula. The relative dielectric constant of a film that had visually observable cracks was not measured, and denoted as "cracked".

$$C=Ca+Cb$$

(wherein C is the capacitance per unit length of a film (pf/m), and is the sum of the capacitance Ca of a flat part and the capacitance Cb of a corner part)

$$Ca=(\varepsilon/\varepsilon_0)\times 2\times(L_1+L_2)/T$$

$$Cb=(\varepsilon/\varepsilon_0)\times 2\pi\varepsilon_0/Log\{(r+T)/r\}/r$$

(wherein $\varepsilon_0$ is the dielectric constant of vacuum, the long side of a copper plate is $L_1$ and the short side is $L_2$, and T is the thickness of a film)

Production of depolymerizable methacrylate resin A:

Methyl methacrylate (1.44 g), n-butyl methacrylate (123.13 g), 2-hydroxyethyl methacrylate (13.92 g), and methacrylic acid (11.51 g) as monomers and azobisisobutyronitrile (1.5 g) as a polymerization initiator were added dropwise to stirred isopropyl alcohol (335 g) over 3 hours while maintaining the liquid temperature at 70°C in a nitrogen atmosphere. Moreover, after the dropwise addition was complete, stirring was continued for 2 hours while maintaining the liquid temperature at 70°C. Thus, a solution of a depolymerizable methacrylate resin A having a resin acid value of 50 mgKOH/g and a solid content of 30% by mass was obtained.

Production of depolymerizable methacrylate resin B:

Methyl methacrylate (7.03 g), n-butyl methacrylate (122.15 g), 2-hydroxyethyl methacrylate (13.92 g), and methacrylic acid (6.9 g) as monomers and azobisisobutyronitrile (1.5 g) as a polymerization initiator were added dropwise to stirred isopropyl alcohol (335 g) over 3 hours while maintaining the liquid temperature at 70°C in a nitrogen atmosphere. Moreover, after the dropwise addition was complete, stirring was continued for 2 hours while maintaining the liquid temperature at 70°C. Thus, a solution of a depolymerizable methacrylate resin B having a resin acid value of 30 mgKOH/g and a solid content of 30% by mass was obtained.

Production of depolymerizable methacrylate resin **C:**

Methyl methacrylate (13.67 g), n-butyl methacrylate (104 g), 2-hydroxyethyl methacrylate (13.92 g), and methacrylic acid (18.41 g) as monomers and azobisisobutyronitrile (1.5 g) as a polymerization initiator were added dropwise to stirred isopropyl alcohol (335 g) over 3 hours while maintaining the liquid temperature at 70°C in a nitrogen atmosphere. Moreover, after the dropwise addition was complete, stirring was continued for 2 hours while maintaining the liquid temperature at 70°C. Thus, a solution of a depolymerizable methacrylate resin C having a resin acid value of 80 mgKOH/g and a solid content of 30% by mass was obtained.

Production of electrodeposition coating material composition A:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding a water dispersion composition (solid content: 30% by mass) of PTFE (relative dielectric constant: 2.2, the number of functional groups: 18 per $10^6$ carbon atoms) particles and pure water so as to achieve perfluoropolymer compound/methacrylate resin = 50/50 (% by mass), to thereby obtain an electrodeposition coating material composition A having a solid content of 15% by mass in which PTFE particles and neutralized particles of the depolymerizable methacrylate resin A were emulsified.

Production of electrodeposition coating material composition B:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding a water dispersion composition (solid content: 30% by mass) of PFA (relative dielectric constant: 2.2, the number of functional groups: 220 per $10^6$ carbon atoms) particles and pure water so as to achieve perfluoropolymer compound/methacrylate resin = 50/50 (% by mass), to thereby obtain an electrodeposition coating material composition B having a solid content of 15% by mass in which PFA particles and neutralized particles of the depolymerizable methacrylate resin A were emulsified.

Production of electrodeposition coating material composition C:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding a water dispersion composition (solid content: 20% by mass) of FEP (relative dielectric constant: 2.2, the number of functional groups: 625 per $10^6$ carbon atoms) particles and pure water so as to achieve perfluoropolymer compound/methacrylate resin = 50/50 (% by mass), to thereby obtain an electrodeposition coating material composition C having a solid content of 15% by mass in which FEP particles and neutralized particles of the depolymerizable methacrylate resin A were emulsified.

Production of electrodeposition coating material composition D:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding a water dispersion composition (solid content: 30% by mass) of PFA (relative dielectric constant: 2.2, the number of functional groups: 220 per $10^6$ carbon atoms) particles and pure water so as to achieve perfluoropolymer compound/methacrylate resin = 30/70 (% by mass), to thereby obtain an electrodeposition coating material composition D having a solid content of 15% by mass in which PFA particles and neutralized particles of the depolymerizable methacrylate resin A were emulsified.

Production of electrodeposition coating material composition E:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding a water dispersion composition (solid content: 30% by mass) of PFA (relative dielectric constant: 2.2, the number of functional groups: 220 per $10^6$ carbon atoms) particles and pure water so as to achieve perfluoropolymer compound/methacrylate resin = 70/30 (% by mass), to thereby obtain an electrodeposition coating material composition E having a solid content of 15% by mass in which PFA particles and neutralized particles of the depolymerizable methacrylate resin A were emulsified.

Production of electrodeposition coating material composition F:

Triethylamine was added to a solution of the depolymerizable methacrylate resin B so as to achieve a degree of neutralization of 80%, to thereby obtain a solution of a neutralized depolymerizable methacrylate resin B. While further stirring the solution, phase inversion emulsification was performed by adding a water dispersion composition (solid content: 30% by mass) of PFA (relative dielectric constant: 2.2, the number of functional groups: 220 per $10^6$ carbon atoms) particles and pure water so as to achieve perfluoropolymer compound/methacrylate resin = 50/50 (% by mass), to thereby obtain an electrodeposition coating material composition F having a solid content of 15% by mass in which PFA particles and neutralized particles of the depolymerizable methacrylate resin B were emulsified.

Production of electrodeposition coating material composition G:

Triethylamine was added to a solution of the depolymerizable methacrylate resin C so as to achieve a degree of neutralization of 80%, to thereby obtain a solution of a neutralized depolymerizable methacrylate resin C. While further stirring the solution, phase inversion emulsification was performed by adding a water dispersion composition (solid content: 30% by mass) of PFA (relative dielectric constant: 2.2, the number of functional groups: 220 per $10^6$ carbon atoms) particles and pure water so as to achieve perfluoropolymer compound/methacrylate resin = 50/50 (% by mass), to thereby obtain an electrodeposition coating material composition F having a solid content of 15% by mass in which PFA particles and neutralized particles of the depolymerizable methacrylate resin C were emulsified.

Production of electrodeposition coating material composition H:

Triethylamine was added to a solution of a non-depolymerizable acrylic resin (Almatex WA911 manufactured by Mitsui Chemicals Inc., a resin acid value of 48 mgKOH/g) so as to achieve a degree of neutralization of 80%, to thereby obtain a solution of a neutralized non-depolymerizable acrylic resin. While further stirring the solution, phase inversion emulsification was performed by adding a water dispersion composition (solid content: 30% by mass) of PFA (relative dielectric constant: 2.2, the number of functional groups: 220 per $10^6$ carbon atoms) particles and pure water so as to achieve perfluoropolymer compound/acrylic resin = 50/50 (% by mass), to thereby obtain an electrodeposition coating

material composition H having a solid content of 15% by mass in which PFA particles and neutralized particles of the non-depolymerizable acrylic resin were emulsified.

Production of electrodeposition coating material composition J:

A water dispersion composition (solid content: 60% by mass) of PTFE (relative dielectric constant: 2.2, the number of functional groups: 18 per $10^6$ carbon atoms) particles and pure water were mixed with a water dispersion composition of depolymerizable methacrylate resin particles (Acryset TF-300 manufactured by Nippon Shokubai Co., Ltd., solid content: 40% by mass, a resin acid value of 0.5 mgKOH/g) so as to achieve perfluoropolymer compound/-methacrylate resin = 50/50 (% by mass), to thereby obtain an electrodeposition coating material composition J having a solid content of 15% by mass.

Production of electrodeposition coating material composition K:

First, 20 kg of a water dispersion composition (solid content: 60% by mass) of PTFE (relative dielectric constant: 2.2, number of functional groups: 18 per $10^6$ carbon atoms) particles, 10 kg of ion exchange water, and 6 g of sodium lauryl sulfate were added, the mixture was stirred for 30 minutes in a nitrogen atmosphere, the temperature was raised to 70°C, a solution obtained by dissolving 6 g of ammonium persulfate and 2 g of sodium hydrogen sulfite in 20 g of pure water was added, and, immediately, 600 g of methyl methacrylate was added dropwise over 30 minutes. Moreover, after the dropwise addition was complete, stirring was continued for 2 hours while maintaining the liquid temperature at 70°C, to thereby obtain a water dispersion composition of particles of the depolymerizable methacrylate resin D (resin acid value: 0.4 mgKOH/g). Next, pure water was added to obtain an electrodeposition coating material composition K having a solid content of 20% by mass in which PTFE particles and particles of the depolymerizable methacrylate resin D were mixed.

Examples 1 to 7, Comparative Examples 1 to 3

Electrodeposition coating was performed on a copper plate using electrodeposition coating material compositions A to H, J, and K at a liquid temperature of 25°C at an applied voltage of 150 V for 120 seconds. This was preliminarily dried at 100°C for 20 minutes, and then heated at 380°C for 20 minutes in a drying oven in a nitrogen-purged, oxygen-free atmosphere to give a film. The properties of this film were evaluated.

Example 8

A coating layer made of a powder coating material composition of PFA (relative dielectric constant: 2.2, number of functional groups: 220 per $10^6$ carbon atoms, MFR: 27 g/10 min) as the fluorine-containing polymer compound Y was formed on the film obtained in Example 2, and the properties of the film and the coating layer (the film and the coating layer are collectively denoted as "film" in Table 3) were evaluated.

Example 9

A coating layer made of a powder coating material composition of PFA (relative dielectric constant: 2.2, number of functional groups: 2 per $10^6$ carbon atoms, MFR: 28 g/10 min) as the fluorine-containing polymer compound Y was formed on the film obtained in Example 2, and the properties of the film and the coating layer (the film and the coating layer are collectively denoted as "film" in Table 3) were evaluated.

Example 10

A coating layer was formed by extruding PFA (relative dielectric constant: 2.2, number of functional groups: 55 per $10^6$ carbon atoms, MFR: 12 g/10 min) as the fluorine-containing polymer compound Z onto the film obtained in Example 2, and the properties of the film and the coating layer (the film and the coating layer are collectively denoted as "film" in Table 3) were evaluated.

Experimental Example 1

Electrodeposition coating was performed on a copper plate using the electrodeposition coating material composition B at a liquid temperature of 25°C at an applied voltage of 150 V for 120 seconds. This was preliminarily dried at 100°C for 20 minutes, and then heated at 380°C for 20 minutes in a drying oven in the presence of oxygen, to which outside air was introduced, to give a film. However, oxidation of the copper plate had progressed, and cracks were

observed in the copper plate.

The results of the above measurements are shown in Table 3.

[Table 3]

Table 3

| | | Example 1 | Example 2 | Example 3 | Example 4 | Example 5 | Example 6 | Example 7 | Example 8 | Example 9 | Example 10 | Experimental Example 1 | Comparative Example 1 | Comparative Example 2 | Comparative Example 3 |
|---|---|---|---|---|---|---|---|---|---|---|---|---|---|---|---|
| Electrodeposition coating material composition | | A | B | C | D | E | F | G | B | B | B | B | H | J | K |
| State of particles | | Simultaneously emulsified particles | Simultaneously emulsified particles | Simultaneously emulsified particles | Simultaneously emulsified particles | Simultaneously emulsified particles | Simultaneously emulsified particles | Simultaneously emulsified particles | Simultaneously emulsified particles | Simultaneously emulsified particles | Simultaneously emulsified particles | Simultaneously emulsified particles | Simultaneously emulsified particles | Mixed particles | Mixed particles |
| Heating environment during formation of film containing polymer compound X | | In the absence of oxygen | In the absence of oxygen | In the absence of oxygen | In the absence of oxygen | In the absence of oxygen | In the absence of oxygen | In the absence of oxygen | In the absence of oxygen | In the absence of oxygen | In the absence of oxygen | In the presence of oxygen | In the absence of oxygen | In the absence of oxygen | In the absence of oxygen |
| Perfluoropolymer compound X (% by mass) | PTFE | 50 | | | | | | | | | | | | 50 | 95 |
| | PFA(1) | | 50 | | 30 | 70 | 50 | 50 | 50 | 50 | 50 | 50 | 50 | | |
| | FEP | | | 50 | | | | | | | | | | | |
| Methacrylate resin (Acrylic resin) (% by mass) | Methacrylate resin A | 50 | 50 | 50 | 70 | 30 | | | 50 | 50 | 50 | 50 | | | |
| | Methacrylate resin B | | | | | | 50 | | | | | | | | |
| | Methacrylate resin C | | | | | | | 50 | | | | | | | |
| | Acrylic resin E | | | | | | | | | | | | 50 | | |
| | Methacrylate resin F | | | | | | | | | | | | | 50 | |
| | Methacrylate resin D | | | | | | | | | | | | | | 5 |
| Fluorine-containing polymer compound Y | PFA(3) | | | | | | | | ○ | | | | | | |
| | PFA(4) | | | | | | | | | ○ | | | | | |
| Fluorine-containing polymer compound Z | PFA(5) | | | | | | | | | | ○ | | | | |
| Properties of electrodeposition coating material composition | Alkali metal content (ppm) | <1.0 | <1.0 | <1.0 | <1.0 | <1.0 | <1.0 | <1.0 | <1.0 | <1.0 | <1.0 | <1.0 | <1.0 | <1.0 | 7.1 |
| Properties of film | Film thickness (μm) | 23 | 20 | 19 | 11 | 34 | 21 | 21 | 74 | 71 | 126 | (Cracking occurred in copper plate) | Cracked | Cracked | Cracked |
| | Surface roughness Ra (μm) of film | 0.4 | 0.4 | 0.3 | 0.4 | 0.3 | 0.5 | 0.4 | 0.4 | 0.4 | 0.3 | | | | |
| | Adhesion strength (N/mm) between film and substrate | 0.2 | 0.4 | 0.7 | 0.4 | 0.4 | 0.4 | 0.4 | 0.5 | 0.5 | 0.7 | | | | |
| | Relative dielectric constant | 2.2 | 2.2 | 2.2 | 2.2 | 2.2 | 2.2 | 2.2 | 2.2 | 2.2 | 2.2 | | | | |

In Table 3, the "simultaneously emulsified particles" means particles of a perfluoropolymer compound and particles of a methacrylate resin (acrylic resin) in the electrodeposition coating material composition obtained by the production method involving adding a water dispersion composition containing the perfluoropolymer compound X and water to a solution containing a methacrylate resin (acrylic resin) and an organic solvent to perform phase inversion emulsification.

In Table 3, the "mixed particles" mean particles of a perfluoropolymer compound and particles of a methacrylate resin (acrylic resin) in the electrodeposition coating material composition obtained by mixing a water dispersion composition containing a methacrylate resin (acrylic resin) and water with a water dispersion composition containing the perfluoropolymer compound X and water.

The respective entries in Table 3 represent the following polymers, and the detailed properties of each polymer are as described above.

Perfluoropolymer compound X

PTFE: Polytetrafluoroethylene, relative dielectric constant: **2.2,** number of functional groups: $18/C10^6$

PFA (1): Tetrafluoroethylene/perfluoro(propyl vinyl ether) copolymer, relative dielectric constant: 2.2, number of functional groups: $220/C10^6$

FEP: Tetrafluoroethylene/hexafluoropropylene copolymer, relative dielectric constant: 2.2, number of functional groups: $625/C10^6$

Methacrylate resin (acrylic resin)

Methacrylate resin A: Depolymerizable methacrylate resin, resin acid value: 50 mgKOH/g

Methacrylate resin B: Depolymerizable methacrylate resin, resin acid value: 30 mgKOH/g

Methacrylate resin C: Depolymerizable methacrylate resin, resin acid value: 80 mgKOH/g

Acrylic resin E: Non-depolymerizable acrylic resin, Almatex WA911 manufactured by Mitsui Chemicals Inc., resin acid value: 48 mgKOH/g

Methacrylate resin F: Depolymerizable methacrylate resin, Acryset TF-300 manufactured by Nippon Shokubai Co., Ltd.,

resin acid value: 0.5 mgKOH/g

Methacrylate resin D: Depolymerizable methacrylate resin, resin acid value: 0.4 mgKOH/g

Fluorine-containing polymer compound Y

PFA (3): Tetrafluoroethylene/perfluoro(propyl vinyl ether) copolymer, relative dielectric constant: 2.2, number of functional groups: 220 per $10^6$ carbon atoms, MFR: 27 g/10 min

PFA (4): Tetrafluoroethylene/perfluoro(propyl vinyl ether) copolymer, relative dielectric constant: 2.2, number of functional groups: 2 per $10^6$ carbon atoms, MFR: 28 g/10 min

Fluorine-containing polymer compound Z

PFA (5): Tetrafluoroethylene/perfluoro(propyl vinyl ether) copolymer, relative dielectric constant: 2.2, number of functional groups: 55 per $10^6$ carbon atoms, MFR: 12 g/10 min

<Measurement of fluorine-containing compound having hydrophilic group>

0. Extraction of fluorine-containing compound having hydrophilic group from aqueous dispersion or water dispersion composition

First, 5.0 g of an aqueous dispersion was weighed, 10 g of methanol was added, the mixture was allowed to flow

into a thimble filter, Soxhlet extraction was performed using methanol as an extraction solvent in a total amount of 150 g, the resulting extract was adjusted to a volume of 250 ml with methanol, to thereby obtain an extract containing a fluorine-containing compound having a hydrophilic group.

<Measurement of perfluoroether carboxylic acid A>

1. Calibration curve of perfluoroether carboxylic acid A

Five concentration levels of methanol standard solutions of perfluoroether carboxylic acid A having known concentrations were prepared, and measurement was made using a liquid chromatograph mass spectrometer (Agilent, Ultivo triple quadrupole LC-MS). First-order approximation was used to create a calibration curve from a methanol standard solution concentration and a peak integral value in the respective concentration ranges.

Measurement equipment configuration and LC-MS measurement conditions

[Table 4]

Table 4 Measuring instrument configuration and LC-MS measurement conditions

| | | | |
|---|---|---|---|
| LC unit | | | |
| | Equipment | 1290 Infinity II manufactured by Agilent | |
| | Column | Zorbax RRHD Extend-C18 1.8 μm (2.1×50 mm) manufactured by Agilent | |
| | Mobile phase | A $CH_3CN$ | |
| | | B 20 mM $CH_3COONH_4/H_2O$ | |
| | | 0→3 min | A:B=60:40 |
| | Flow rate | 0.3ml/min | |
| | Column temperature | 40°C | |
| | Amount of injected sample | 1 μL | |
| MS unit | | | |
| | Equipment | Ultivo LC/TQ manufactured by Agilent | |
| | Measurement mode | MRM (Multiple Reaction Monitoring) | |
| | Ionization method | Electrospray ionization<br>Negative mode | |

MRM measurement parameters

[Table 5]

Table 5 MRM measurement parameters

| Compound | Precursor | Product |
|---|---|---|
| Perfluoroether carboxylic acid A | 395 | 351 |

2. Content of perfluoroether carboxylic acid A contained in aqueous dispersion or water dispersion composition

Perfluoroethercarboxylic acid A was measured using a liquid chromatograph-mass spectrometer. The extract was suitably diluted with methanol to prepare a measurement solution such that the amount of perfluoroethercarboxylic acid A in the measurement solution was within the calibration curve. Concerning the measurement solution, the peak area of perfluoroethercarboxylic acid A was determined using MRM method, and the content of perfluoroethercarboxylic acid A was determined from the calibration curve.

<Content of compound represented by general formula (H2) >

The content of the compound represented by the general formula (H2) was determined using a calibration curve

of linear perfluorocarboxylic acids having the same number of carbon atoms.

1. Calibration curve of perfluorocarboxylic acid

Five concentration levels of methanol standard solutions of perfluorobutanoic acid, perfluoropentanoic acid, perfluorohexanoic acid, perfluoroheptanoic acid, perfluorooctanoic acid, perfluorononanoic acid, perfluorodecanoic acid, perfluoroundecanoic acid, perfluorododecanoic acid, perfluorotridecanoic acid, and perfluorotetradecanoic acid having known concentrations were prepared, and measurement was made using a liquid chromatograph mass spectrometer (Agilent, Ultivo triple quadrupole LC-MS). First-order approximation was used to create a calibration curve from a methanol standard solution concentration and a peak integral value in the respective concentration ranges.

Measurement equipment configuration and LC-MS measurement conditions

[Table 6]

Table 6 Measuring instrument configuration and LC-MS measurement conditions

| LC unit | | | |
|---|---|---|---|
| | Equipment | 1290 Infinity II manufactured by Agilent | |
| | Column | Zorbax RRHD Extend-C18 1.8 µm (2.1×50 mm) manufactured by Agilent | |
| | Mobile phase | A $CH_3CN$ | |
| | | B 20 mM $CH_3COONH_4/H_2O$ | |
| | | 0→1 min | A:B=10:90 |
| | | 1→6 min | A:B=10:90 → A:B=95:5 Linear gradient |
| | | 6→12 min | A:B=95:5 |
| | Flow rate | 0.3ml/min | |
| | Column temperature | 40°C | |
| | Amount of injected sample | 1 µL | |
| MS unit | | | |
| | Equipment | Ultivo LC/TQ manufactured by | |
| | Measurement mode | MRM (Multiple Reaction Monitoring) | |
| | Ionization method | Electrospray ionization | |
| | | Negative mode | |

MRM measurement parameters

[Table 7]

Table 7 MRM measurement parameters

| Compound | Number of carbon atoms | Precursor | Product |
|---|---|---|---|
| Perfluorobutanoic acid | 4 | 213 | 169 |
| Perfluoropentanoic acid | 5 | 263 | 219 |
| Perfluorohexanoic acid | 6 | 313 | 269 |
| Perfluoroheptanoic acid | 7 | 363 | 319 |
| Perfluorooctanoic acid | 8 | 413 | 369 |
| Perfluorononanoic acid | 9 | 463 | 419 |
| Perfluorodecanoic acid | 10 | 513 | 469 |
| Perfluoroundecanoic acid | 11 | 563 | 519 |
| Perfluorododecanoic acid | 12 | 613 | 569 |
| Perfluorotridecanoic acid | 13 | 663 | 619 |
| Perfluorotetradecanoic acid | 14 | 713 | 669 |

3. Content of compound represented by general formula (H2) contained in aqueous dispersion or water dispersion composition

Using a liquid chromatograph mass spectrometer, the content of compounds represented by the general formula (H2) having n carbon atoms and contained in the extract was measured from a calibration curve. Concerning the extract, the peak area of fluorine-containing compounds having a hydrophilic group represented by the general formula (H2) was determined using MRM method, and the content of fluorine-containing compounds having a hydrophilic group represented by the general formula (H2) contained in the aqueous dispersion or the water dispersion composition was determined.

MRM measurement parameters

[Table 8]

Table 8 MRM measurement parameters

| Compound | Number of carbon atoms | Precursor | Product |
|---|---|---|---|
| $[C_3F_7COO^-]M^+$ | 4 | 213 | 169 |
| $[C_4F_9COO^-]M^+$ | 5 | 263 | 219 |
| $[C_5F_{11}COO^-]M^+$ | 6 | 313 | 269 |
| $[C_6F_{13}COO^-]M^+$ | 7 | 363 | 319 |
| $[C_7F_{15}COO^-]M^+$ | 8 | 413 | 369 |
| $[C_8F_{17}COO^-]M^+$ | 9 | 463 | 419 |
| $[C_9F_{19}COO^-]M^+$ | 10 | 513 | 469 |
| $[C_{10}F_{21}COO^-]M^+$ | 11 | 563 | 519 |
| $[C_{11}F_{23}COO^-]M^+$ | 12 | 613 | 569 |
| $[C_{12}F_{25}COO^-]M^+$ | 13 | 663 | 619 |
| $[C_{13}F_{27}COO^-]M^+$ | 14 | 713 | 669 |

Synthesis Example 1

A white solid A of perfluoroether carboxylic acid A having a molecular weight of 1,000 or less was obtained by the method described in Synthesis Example 1 of International Publication No. WO 2021/045228.

Production Example 1

First, 3,750 g of deionized water and 5.49 g of white solid A obtained in Synthesis Example 1 as a fluorine-containing surfactant were added to a stirrer-equipped SUS reactor having an internal volume of 6 L. Then, the contents of the reactor were suctioned while being heated to 60°C and, at the same time, the reactor was purged with TFE to remove oxygen in the reactor, and the contents were stirred. After 6.9 g of methylene chloride and 27 g of perfluoro(propyl vinyl ether) (PPVE) were added to the reactor, TFE was added until a pressure of 1.3 MPaG was reached. Then, 990 mg of an ammonium persulfate (APS) initiator dissolved in 20 g of deionized water was added to the reactor. The pressure dropped after injection of the initiator, and the initiation of polymerization was observed. TFE was added to the reactor to maintain a constant pressure of 1.3 MPaG. After the initiation of polymerization, PPVE was continuously added so as to be 4 g per 100 g of TFE. When TFE consumed in the reaction reached about 1,600 g, the feeding of TFE was stopped and stirring was stopped to terminate the reaction. Then, the reactor was evacuated until the pressure inside the reactor reached normal pressure, to obtain an aqueous tetrafluoroethylene/perfluoro(propyl vinyl ether) copolymer (PFA) dispersion.

Preparation Example 1

The aqueous PFA dispersion obtained in Production Example 1 was placed in a different reactor, the contents of the reactor were heated to 80°C, and 30.3 g of ammonium persulfate was added as a radical generator (in an amount of 10 mol per mole of the fluorine-containing surfactant used in the polymerization). Then, the temperature was maintained at 80°C for 3 hours to obtain a water dispersion composition containing heat-treated PFA.

Next, embodiments of electrodeposition coating material compositions containing the aqueous dispersion obtained in Production Example 1 or the water dispersion composition obtained in Preparation Example 1 will now be described by way of Examples.

Production of electrodeposition coating material composition B:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding the aqueous dispersion obtained in Preparation Example 1 (the relative dielectric constant of PFA: 2.2, the number of functional groups in PFA: 220 per $10^6$ carbon atoms, the content of fluorine-containing compound having hydrophilic group based on PFA: 42 mass ppb, solid content: 30% by mass) so as to achieve perfluoropolymer compound/methacrylate resin = 50/50 (% by mass), to thereby obtain an electrodeposition coating material composition B having a solid content of 15% by mass in which PFA particles and neutralized particles of the depolymerizable methacrylate resin A were emulsified.

Production of electrodeposition coating material composition L:

Triethylamine was added to a solution of the depolymerizable methacrylate resin A so as to achieve a degree of neutralization of 80%, to thereby obtain a solution of a neutralized depolymerizable methacrylate resin A. While further stirring the solution, phase inversion emulsification was performed by adding the aqueous dispersion obtained in Production Example 1 (the relative dielectric constant of PFA: 2.2, the number of functional groups in PFA: 220 per $10^6$ carbon atoms, the content of fluorine-containing compound having hydrophilic group based on PFA: 551 mass ppb, solid content: 30% by mass) so as to achieve perfluoropolymer compound/methacrylate resin = 50/50 (% by mass), to thereby obtain an electrodeposition coating material composition L having a solid content of 15% by mass in which PFA particles and neutralized particles of the depolymerizable methacrylate resin A were emulsified.

Example 11, Experimental Example 2

Electrodeposition coating was performed on a copper plate using the electrodeposition coating material composition B (Example 11) and the electrodeposition coating material composition L (Experimental Example 2), at a liquid temperature of 25°C at an applied voltage of 150 V for 120 seconds. This was preliminarily dried at 100°C for 20 minutes, and then heated at 380°C for 20 minutes in a drying oven in a nitrogen-purged, oxygen-free atmosphere to give a film. The contact angle and the coefficient of friction of this film were measured in the following manner.

<Contact angle>

The contact angle with respect to water and n-cetane was measured using a contact angle tester CA-DT manufactured by Kyowa Interface Science Co., Ltd.

<Coefficient of friction>

Using a surface quality tester HEIDON Type 38 manufactured by Shinto Scientific Co., Ltd., the coefficient of static friction and the coefficient of kinetic friction when a ball indenter was pressed under a load of 1 kg and moved at a speed of 600 mm/min were measured.

The results of the above are shown in Table 9.

[Table 9]

**Table 9**

| | Unit | Example 11 | Experimental Example 2 |
|---|---|---|---|
| Contact angle (water) | Degree | 101 | 88 |
| Contact angle (n-cetane) | Degree | 34 | 25 |
| Coefficient of static friction | - | 0.15 | 0.25 |
| Coefficient of kinetic friction | - | 0.06 | 0.15 |

## Claims

1. An electrodeposition coating material composition comprising a perfluoropolymer compound X and a neutralized product of a methacrylate resin, wherein

    the perfluoropolymer compound X has a relative dielectric constant of 2.0 to 2.2,
    the methacrylate resin has an acid value of 10 mgKOH/g or more, and
    the electrodeposition coating material composition has a solid concentration of 10 to 70% by mass.

2. An electrodeposition coating material composition comprising a perfluoropolymer compound X and a neutralized product of a methacrylate resin, wherein

    the perfluoropolymer compound X is a tetrafluoroethylene/fluoroalkyl vinyl ether copolymer,
    the methacrylate resin has an acid value of 10 mgKOH/g or more, and
    the electrodeposition coating material composition has a solid concentration of 10 to 70% by mass.

3. The electrodeposition coating material composition according to claim 1 or 2, wherein a content of a fluorine-containing compound having a hydrophilic group is 50 mass ppb or less based on the perfluoropolymer compound X.

4. The electrodeposition coating material composition according to any one of claims 1 to 3, further comprising water.

5. The electrodeposition coating material composition according to any one of claims 1 to 4, which is obtained by a production method comprising phase inversion emulsification by adding a water dispersion composition containing the perfluoropolymer compound X and water to a solution containing the neutralized product of the methacrylate resin and an organic solvent.

6. The electrodeposition coating material composition according to any one of claims 1 to 5, wherein the methacrylate resin has carboxyl group, and the neutralized product of the methacrylate resin is a neutralized product obtained by neutralizing the methacrylate resin having carboxyl group with an amine compound.

7. The electrodeposition coating material composition according to any one of claims 1 to 6, wherein the neutralized product of the methacrylate resin has a degree of neutralization of 50% or more.

8. The electrodeposition coating material composition according to any one of claims 1 to 7, wherein the perfluoropolymer compound X has a functional group, and the number of functional groups in the perfluoropolymer compound X is 5 to 2,000 per $10^6$ carbon atoms.

**9.** The electrodeposition coating material composition according to any one of claims 1 to 8, having an alkali metal content of less than 1 mass ppm.

**10.** The electrodeposition coating material composition according to any one of claims 1 to 9, wherein a mass ratio of the perfluoropolymer compound X to the neutralized product of the methacrylate resin is 10/90 to 90/10.

**11.** A film formed from the electrodeposition coating material composition according to any one of claims 1 to 10.

**12.** A coated article comprising a substrate and a film with which the substrate is coated, wherein
the film is formed from the electrodeposition coating material composition according to any one of claims 1 to 10.

**13.** The coated article according to claim 12, wherein a material that forms the substrate is at least one selected from the group consisting of copper, copper alloy, aluminum, and aluminum alloy.

**14.** A coated electric wire comprising a rectangular electric wire substrate and a film formed around the rectangular electric wire substrate, wherein
the film is formed from the electrodeposition coating material composition according to any one of claims 1 to 10.

**15.** The coated electric wire according to claim 14, wherein a material that forms the rectangular electric wire substrate is at least one selected from the group consisting of copper, copper alloy, aluminum, and aluminum alloy.

**16.** The coated electric wire according to claim 14 or 15, having a bent part.

**17.** The coated electric wire according to claim 14 or 15, which is a continuous electric wire.

**18.** The coated electric wire according to any one of claims 14 to 17, further comprising a coating layer formed around the film, wherein
the coating layer is a layer formed from a powder coating material composition comprising a fluorine-containing polymer compound Y.

**19.** The coated electric wire according to any one of claims 14 to 17, further comprising a coating layer formed around the film, wherein
the coating layer is a layer formed by extrusion forming of a fluorine-containing polymer compound Z.

**20.** The coated electric wire according to claim 18, wherein the fluorine-containing polymer compound Y is a perfluoropolymer compound,

the fluorine-containing polymer compound Y has a relative dielectric constant of 2.0 to 2.2, and
the fluorine-containing polymer compound Y has a melting point of 250 to 320°C.

**21.** The coated electric wire according to claim 18, wherein the fluorine-containing polymer compound Y has a melt flow rate of 0.1 to 100 g/10 min.

**22.** The coated electric wire according to claim 18, wherein the fluorine-containing polymer compound Y has a functional group, and the number of functional groups is 5 to 1,000 per $10^6$ carbon atoms.

**23.** The coated electric wire according to claim 18, wherein the fluorine-containing polymer compound Y has a functional group, and the number of functional groups is 0 to 4 per $10^6$ carbon atoms.

**24.** A printed circuit board comprising a substrate and a film with which the substrate is coated, wherein
the film is formed from the electrodeposition coating material composition according to any one of claims 1 to 10.

**25.** The printed circuit board according to claim 24, wherein a material that forms the substrate is at least one selected from the group consisting of copper, copper alloy, aluminum, and aluminum alloy.

Figure 1

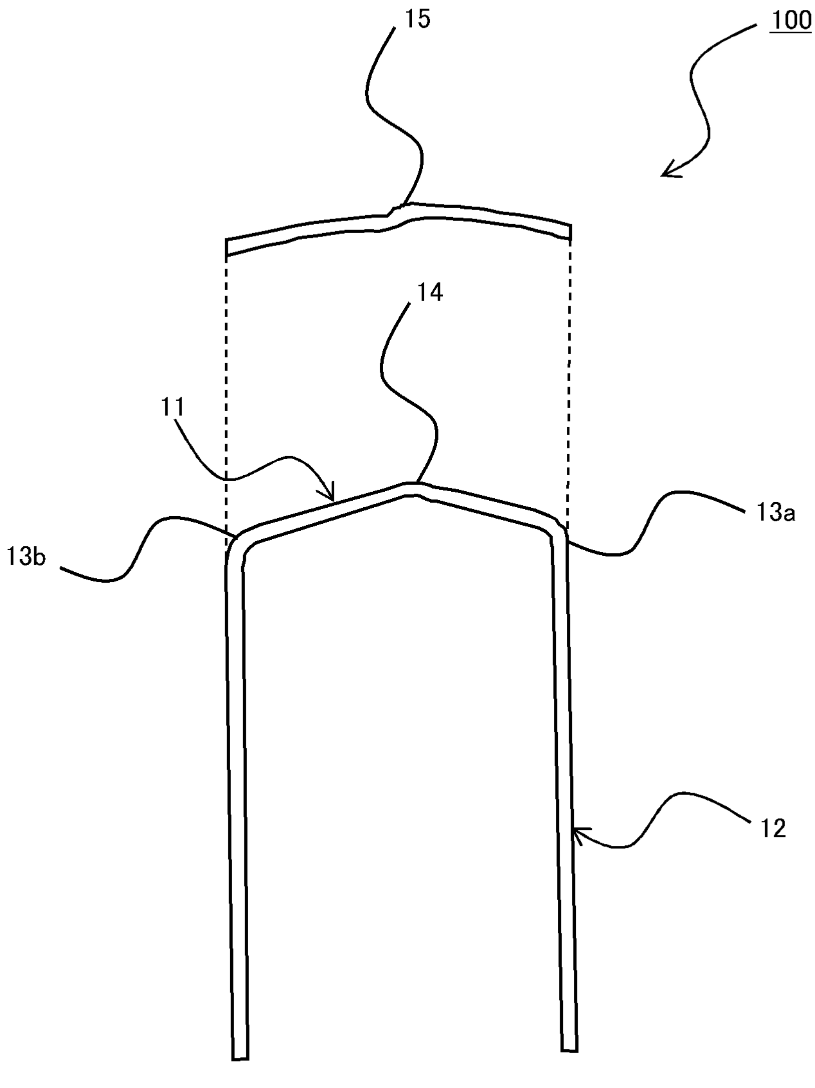

Figure 2

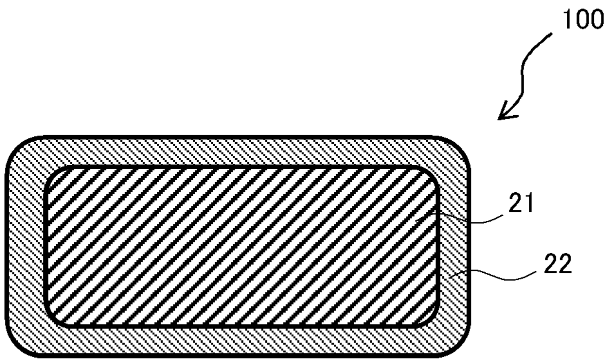

## INTERNATIONAL SEARCH REPORT

International application No.
**PCT/JP2023/039665**

### A. CLASSIFICATION OF SUBJECT MATTER

***C09D 133/10***(2006.01)i; ***C09D 5/02***(2006.01)i; ***C09D 5/44***(2006.01)i; ***C09D 127/12***(2006.01)i; ***H01B 7/02***(2006.01)i
FI: C09D133/10; C09D5/44; C09D127/12; C09D5/02; H01B7/02 C

According to International Patent Classification (IPC) or to both national classification and IPC

### B. FIELDS SEARCHED

Minimum documentation searched (classification system followed by classification symbols)

C09D; H01B7/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y | JP 2017-179209 A (LIXIL CORP) 05 October 2017 (2017-10-05) claim 1, examples 1-6, paragraph [0049] | 1, 4, 6-7, 11-12 |
| Y | JP 2022-108653 A (MITSUBISHI MATERIALS CORP) 26 July 2022 (2022-07-26) paragraph [0024], table 1 | 1, 4, 6-7, 11-12 |
| A | WO 2022/050430 A1 (DAIKIN INDUSTRIES, LTD.) 10 March 2022 (2022-03-10) entire text | 1-25 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 December 2023** | **26 December 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2023/039665**

| Patent document cited in search report | Publication date (day/month/year) | Patent family member(s) | Publication date (day/month/year) |
|---|---|---|---|
| JP 2017-179209 A | 05 October 2017 | US 2019/0367764 A1<br>claim 1, examples 1-6<br>WO 2017/170852 A1<br>EP 3438218 A1<br>CN 108884353 A | |
| JP 2022-108653 A | 26 July 2022 | WO 2022/154052 A1 | |
| WO 2022/050430 A1 | 10 March 2022 | US 2023/0203297 A1<br>entire text<br>EP 4212556 A1<br>CN 115956091 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2002298674 A
- JP S61042822 A
- JP 2006152234 A
- WO 2017122743 A
- US 20070015864
- US 20070015865
- US 20070015866
- US 20070276103
- US 20070117914
- US 2007142541
- US 20080015319
- US 3250808 A
- US 3271341 A
- JP 2003119204 A
- WO 2005042593 A
- WO 2008060461 A
- WO 2007046377 A
- JP 2007119526 A
- WO 2007046482 A
- WO 2007046345 A
- US 20140228531
- WO 2013189824 A
- WO 2013189826 A
- WO 2019161153 A
- WO 2021045228 A